# EUROPÄISCHE PATENTSCHRIFT

(11) **EP 2 823 566 B1**
(45) Veröffentlichungstag und Bekanntmachung des Hinweises auf die Patenterteilung: **23.12.2020**
(21) Anmeldenummer: 13701091.4
(22) Anmeldetag: 24.01.2013
(51) Int. Cl.: H03M 1/10, H03M 1/12

(54) **ANALOG-DIGITAL-WANDLERANORDNUNG UND ZUGEHÖRIGES VERFAHREN ZUR ÜBERPRÜFUNG EINES MULTIPLEXERS FÜR EINEN ANALOG-DIGITAL-WANDLER**
ANALOGUE-TO-DIGITAL CONVERTER ARRANGEMENT AND ASSOCIATED METHOD FOR CHECKING A MULTIPLEXER FOR AN ANALOGUE-TO-DIGITAL CONVERTER
ENSEMBLE CONVERTISSEUR ANALOGIQUE-NUMÉRIQUE ET PROCÉDÉ ASSOCIÉ SERVANT À LA VÉRIFICATION D'UN MULTIPLEXEUR DESTINÉ À UN CONVERTISSEUR ANALOGIQUE-NUMÉRIQUE

(30) Priorität: 08.03.2012 DE 102012203670
(43) Veröffentlichungstag der Anmeldung: 14.01.2015
(73) Patentinhaber: Robert Bosch GmbH, 70442 Stuttgart (DE)
(72) Erfinder: KARNER, Ruediger, 70806 Kornwestheim (DE)
(86) Internationale Anmeldenummer: PCT/EP2013/051312
(87) Internationale Veröffentlichungsnummer: WO 2013/131685

(56) Entgegenhaltungen:
- EP-A2- 1 641 126
- US-A1- 2007 252 744
- US-A1- 2010 235 699
- US-B1- 6 396 426
- UTLEY ET AL: "Checking Circuit for Analog Input Systems", COMPUTER DESIGN, PENNWELL PUBL. LITTLETON, MASSACHUSETTS, US, Bd. 12, Nr. 12, Dezember 1973 (1973-12), Seite 106, XP002107327, ISSN: 0010-4566

## Beschreibung

### Stand der Technik

Die Erfindung geht aus von einer Analog-Digital-Wandleranordnung nach der Gattung des unabhängigen Patentanspruchs 1 und von einem zugehörigen Verfahren zur Überprüfung eines Multiplexers für einen Analog-Digital-Wandler nach der Gattung des unabhängigen Patentanspruchs 11.

Häufig wird vor Analog-Digital-Wandler ein Multiplexer geschaltet, um Analogsignale von mehreren Eingängen mit einem einzigen Analog-Digitalwandler in korrespondierende Digitalsignale umzuwandeln. Ein möglicher Fehler des Multiplexers, wie beispielsweise ein Kurzschluss zu einem anderen Potential, eine Verkopplung mehrerer Kanäle untereinander oder eine Unterbrechung in einem der Kanäle wird nicht erkannt. Um eine solche Analog-Digital-Wandleranordnung mit Multiplexer und Analog-Digital-Wandler für sicherheitsrelevante Größen verwenden zu können, ist eine Zuverlässigkeitsprüfung erforderlich. Die Analog-Digital-Wandleranordnung kann beispielsweise als Teil einer Sensoranordnung ausgebildet werden, welche als ASIC (Application-Specific Integrated Circuit: Anwendungsspezifische integrierte Schaltung) ausgeführt werden kann.

Die momentan gebräuchlichen Verfahren führen die Überprüfung des Multiplexers, wenn überhaupt, über eine Vielzahl von Kommandos und ein Softwareprogramm aus, welches in einem korrespondierenden Steuergerät durch einen Mikrocontroller abgearbeitet wird. Hierbei muss der Programmablauf dann immer noch auf die Abarbeitung der Operationen des ASICs warten, bevor der nächste Programmschritt zur Überprüfung gestartet werden kann. Dies führt zu einem großen Softwareaufwand und zu langen oftmals ungenutzten Wartezeiten des Mikrocontrollers während der Testphase.

In der Offenlegungsschrift DE 10 2008 042 400 A1 werden beispielsweise ein Verfahren und eine Korrekturvorrichtung zur Korrektur eines Offsetfehlers einer Analog-Digital-Wandleranordnung beschrieben. Die beschriebene Korrekturvorrichtung umfasst einen Multiplexer zum Verbinden eines Eingangs eines Analog-Digital-Wandlers mit zumindest einem Mess-Kanal oder einem Offsetkanal. Der Offsetkanal stellt einen vordefinieren Referenzspannungswert oder einen vordefinieren Referenzstromwert bereit. Eine Recheneinheit speichert einen von einem Ausgang des Analog-Digital-Wandlers bereitgestellten Wert als Offsetwert in einem Speicher oder verknüpft einen vom Ausgang des Analog-Digital-Wandlers bereitgestellten Wert als Messwert mit dem gespeicherten Offsetwert auf Basis einer Verknüpfungsstruktur und stellt den erhaltenen Wert als korrigierten Messwert einer Übertragungseinheit zur Verfügung. Des Weiteren ist eine Steuereinheit vorgesehen, welche den Multiplexer und die Recheneinheit in einen ersten oder zweiten Betriebsmodus schaltet, wobei im ersten Betriebsmodus der Eingang des Analog-Digital-Wandlers mit dem Offsetkanal verbunden ist und der vom Ausgang des Analog-Digital-Wandlers bereitgestellte Wert in der Recheneinheit als Offsetfehlerwert interpretiert wird, und im zweiten Betriebsmodus der Eingang des Analog-Digital-Wandlers mit einem Mess-Kanal verbunden wird und der vom Ausgang bereitgestellte Wert in der Recheneinheit als Messwert interpretiert wird.

Aus den Druckschriften US 2010/023699 A1, US 2007/252744 A1 und EP 1 641 126 A2 sowie dem Artikel: UTLEY ET AL: "Checking Circuit for Analog Input Systems", COMPUTER DESIGN, PENNWELL PUBL. LITTLETON, MASSACHUSETTS, US, Bd. 12, Nr. 12, Dezember 1973 (1973-12), Seite 106, ISSN: 0010-4566, ist jeweils eine Analog-Digital-Wandleranordnung mit einem Multiplexer, welcher mehrere Kanäle mit mindestens einem Schalter umfasst, wobei der mindestens eine Schalter ein Eingangsportal des Kanals mit einem korrespondierenden Ausgangsportal verbindet, und einem Analog-Digital-Wandler bekannt, dessen Analogeingang mit dem Ausgangsportal des Multiplexers verbunden ist. Zudem ist in mindestens einem Kanal mindestens ein weiterer Schalter zum Testen des Multiplexers vorgesehen, welcher das Eingangsportal und/oder das Ausgangsportal des korrespondierenden Kanals und/oder den korrespondierenden Kanal mit einem vorgegebenen Spannungspotential verbindet.

Aus der US 6,396,426 B1 ist eine gattungsgemäße Analog-Digital-Wandleranordnung mit einem Multiplexer, welcher mehrere Kanäle mit mindestens einem Schalter und mit mindestens einem Widerstand umfasst, wobei der mindestens eine Schalter ein Eingangsportal des Kanals mit einem korrespondierenden Ausgangsportal verbindet, und einem Analog-Digital-Wandler bekannt, dessen Analogeingang mit dem Ausgangsportal des Multiplexers verbunden ist. In mindestens einem der mehreren Kanäle ist mindestens ein weiterer Schalter zum Testen des Multiplexers vorgesehen, welcher das Eingangsportal des mindestens einen Kanals und/oder das Ausgangsportal des mindestens einen Kanals und/oder den mindestens einen Kanal mit einem vorgegebenen Spannungspotential verbindet. Zudem ist eine Logikschaltung vorgesehen, welche den mindestens einen Schalter und den mindestens einen weiteren Schalter schaltet, wobei in der Logikschaltung eine Ablaufsteuerung implementiert ist, welche die einzelnen Kanäle in einer vorgegebenen Reihenfolge durch Ansteuern der korrespondierenden Schalter überprüft.

### Offenbarung der Erfindung

Die erfindungsgemäße Analog-Digital-Wandleranordnung mit den Merkmalen des unabhängigen Patentanspruchs 1 und das erfindungsgemäße Verfahren zur Überprüfung eines Multiplexers für einen Analog-Digital-Wandler mit den Merkmalen des unabhängigen Patentanspruchs 11 haben demgegenüber den Vorteil, dass ein Multiplexer einer Analog-Digital-Wandleranordnung innerhalb der Analog-Digital-Wandleranordnung automatisch getestet werden kann. Das bedeutet, dass über einen Softwarebefehl, welcher beispielsweise von einem Steuergerät ausgegeben wird, vorzugsweise eine automatisch ablaufende Ablaufsteuerung innerhalb der Analog-Digital-Wandleranordnung aktiviert werden kann, welche die einzelnen Testbedingungen für den Multiplexer aktiviert und auswertet, so dass eine umfassende Überprüfung der kompletten Analog-Digital-Wandleranordnung möglich ist. Das Ergebnis der Überprüfung kann dann von einem Steuergerät über einen Softwarebefehl abgeholt werden.

Die Grundidee der vorliegenden Erfindung basiert auf einer komplexen Logikschaltung, welche in der Analog-Digital-Wandleranordnung angeordnet ist und einfache Ablaufsteuerungen durchführen kann, so dass es möglich ist, in Reaktion auf einen Softwarebefehl einen Testbetrieb zu starten, welcher testet ob die einzelnen Eingangsportale der Kanäle des Multiplexers nach Masse oder zu einem anderen Potential kurzgeschlossen sind und/oder ob die einzelnen Kanäle des Multiplexers einen internen Kurzschluss zu einem anderen Spannungspotential aufweisen und/oder mit einem anderen Kanal verkoppelt sind.

Die Logikschaltung kann während des Testbetriebs verschiedene Messungen durchführen, um zu erkennen, ob die einzelnen Kanäle des Multiplexers interne und/oder externe Kurzschlüsse zu anderen Spannungspotentialen aufweisen. Des Weiteren kann die Logikschaltung verschiedene Messungen durchführen, um zu erkennen, ob mehrere Multiplexerkanäle verkoppelt sind, was zu unbemerkten Fehlmessungen führen würde. Bei den Verkopplungstests werden zwei ineinander verschachtelte Schleifen abgearbeitet, wobei Stimuli-Kanäle und Mess-Kanäle unterschieden werden. An einen Stimuli-Kanal wird ein vorgegebenes Spannungspotential angelegt und gemessen und an den Mess-Kanälen wird nur gemessen. Bei den internen Verkopplungstests wird der jeweilige Stimuli-Kanal mit einem internen Spannungspotential verbunden und bei den externen Verkopplungstests wird ein externes Spannungspotential an das Eingangsportal des jeweiligen Stimuli-Kanals angelegt. Die Ergebnisse der einzelnen Messreihen können gespeichert und auf Anforderung ausgegeben werden. Da alle Tests bzw. Messungen nach dem Starten des Testbetriebs durch den Softwarebefehl automatisch ablaufen, ist das korrespondierende Steuergerät bzw. der Mikrocontroller im korrespondierenden Steuergerät von den ganzen Tests bzw. Messungen unbeeinflusst und kann in dieser Zeit andere Prozesse bearbeiten. Nach Beendigung des automatischen Testbetriebs können die Messergebnisse dann bei Bedarf abgeholt werden.

Ausführungsformen der vorliegenden Erfindung stellen eine Analog-Digital-Wandleranordnung mit einem Multiplexer, welcher mehrere Kanäle mit mindestens einem Schalter umfasst, und einem Analog-Digital-Wandler zur Verfügung, dessen Analogeingang mit dem Ausgangsportal des Multiplexers verbunden ist. Zudem ist in mindestens einem Kanal mindestens ein weiterer Schalter zum Testen des Multiplexers vorgesehen, welcher das Eingangsportal und/oder das Ausgangsportal des korrespondierenden Kanals und/oder den korrespondierenden Kanal mit einem vorgegebenen Spannungspotential verbindet. Hierbei ist eine Logikschaltung vorgesehen, welche den mindestens einen Schalter und den mindestens einen weiteren Schalter eines jeweiligen Kanals schaltet und ein Eingangsportal des Kanals mit einem korrespondierenden Ausgangsportal verbindet, wobei in der Logikschaltung eine Ablaufsteuerung implementiert ist, welche die einzelnen Kanäle in einer vorgegebenen Reihenfolge durch Ansteuern der korrespondierenden Schalter dahingehend überprüft, ob der jeweilige Kanal mit einem anderen Kanal verkoppelt ist. Zusätzlich kann die Ablaufsteuerung überprüfen, ob der jeweilige Kanal einen internen und/oder externen Kurzschluss zu einem anderen Spannungspotential aufweist. Der mindestens eine weitere Schalter kann vorzugsweise in einem Testbetrieb geschaltet werden, wobei die Ablaufsteuerung in der Logikschaltung während des Testbetriebs aktiviert ist.

Des Weiteren wird ein Verfahren zur Überprüfung eines Multiplexers für einen Analog-Digital-Wandler vorgeschlagen, wobei der Multiplexer mehrere Kanäle mit mindestens einem Schalter umfasst, welche geschaltet werden und ein Eingangsportal des jeweiligen Kanals mit einem korrespondierenden Ausgangsportal verbinden. Zudem wird in mindestens einem Kanal mindestens ein weiterer Schalter zum Testen des Multiplexers vorgesehen, mittels welchem das Eingangsportal und/oder das Ausgangsportal des korrespondierenden Kanals und/oder der korrespondierende Kanal mit einem vorgegebenen Spannungspotential verbunden werden. Hierbei ist eine Ablaufsteuerung implementiert, welche die einzelnen Kanäle in einer vorgegebenen Reihenfolge durch Ansteuern der korrespondierenden Schalter dahingehend überprüft, ob der jeweilige Kanal mit einem anderen Kanal verkoppelt ist. Zusätzlich kann die Ablaufsteuerung überprüfen, ob der jeweilige Kanal einen internen und/oder externen Kurzschluss zu einem anderen Spannungspotential aufweist. Der mindestens eine weitere Schalter kann vorzugsweise in einem Testbetrieb geschaltet werden, wobei die Ablaufsteuerung in der Logikschaltung während des Testbetriebs aktiviert wird.

Durch die in den abhängigen Ansprüchen aufgeführten Maßnahmen und Weiterbildungen sind vorteilhafte Verbesserungen der im unabhängigen Patentanspruch 1 angegebenen Analog-Digital-Wandleranordnung und des im unabhängigen Patentanspruch 11 angegebenen Verfahrens zur Überprüfung eines Multiplexers für einen Analog-Digital-Wandler möglich.

In vorteilhafter Ausgestaltung der erfindungsgemäßen Analog-Digital-Wandleranordnung können eine Spannungsversorgung und eine Auswahleinheit zur Bereitstellung von mindestens einem vorgegebenen externen Spannungspotential vorgesehen werden. Die Spannungsversorgung kann beispielsweise mehrere Referenzspannungspegel zur Verfügung stellen, welche zum Überprüfen des Multiplexers und des Analog-Digital-Wandlers verwendet werden können. Die Spannungsversorgung stellt beispielsweise einen ersten Referenzspannungspegel, welcher durch den Analog-Digital-Wandler in einen maximalen digitalen Wert umgewandelt wird, einen zweiten Referenzspannungspegel, welcher durch den Analog-Digital-Wandler in einen digitalen Wert umgewandelt wird, welcher etwa 75% des Maximalwerts entspricht, einen dritten Referenzspannungspegel, welcher durch den Analog-Digital-Wandler in einen digitalen Wert umgewandelt wird, welcher etwa 50% des Maximalwerts entspricht, und einen vierten Referenzspannungspegel zur Verfügung, welcher durch den Analog-Digital-Wandler in einen digitalen Wert umgewandelt wird, welcher etwa 25% des Maximalwerts entspricht. Zudem kann ein Massepotential zur Verfügung gestellt werden. Die Auswahl der einzelnen Referenzspannungspegel kann dann über die Auswahleinheit erfolgen.

In weiterer vorteilhafter Ausgestaltung der erfindungsgemäßen Analog-Digital-Wandleranordnung kann die Logikschaltung den Analog-Digital-Wandler als Messelement verwenden, welches das resultierende Spannungspotential am Ausgangsportal des Multiplexers basierend auf Kriterien ermitteln kann, welche von der Ablaufsteuerung vorgegeben werden können. Diese Kriterien können beispielsweise bestimmte Schaltzustände der Schalter im Multiplexer oder in der Auswahleinheit umfassen.

In weiterer vorteilhafter Ausgestaltung der erfindungsgemäßen Analog-Digital-Wandleranordnung kann die Logikschaltung das am Ausgangsportal des Multiplexers ermittelte resultierende Spannungspotential basierend auf vorgegebenen Kriterien auswerten, welche von der Ablaufsteuerung vorgegeben werden. Diese vorgegebenen Auswertekriterien können beispielsweise Schwellwerte, Wertebereiche usw. umfassen, mit welchen die ermittelten resultierenden Spannungspotentiale verglichen werden. Die Logikschaltung kann das am Ausgangsportal des Multiplexers ermittelte resultierende Spannungspotential beispielsweise mit mindestens einem vorgegebenen Schwellwert vergleichen und das Vergleichsergebnis in mindestens einem Speicher ablegen. Zur Feststellung, ob das ermittelte resultierende Spannungspotential innerhalb eines vorgegebenen Wertebereichs liegt, überprüft die Logikschaltung beispielsweise ob das ermittelte resultierende Spannungspotential einen ersten Schwellwert überschreitet und gleichzeitig einen zweiten Schwellwert unterschreitet, wobei die beiden Schwellwerte die Grenzen des Wertebereichs repräsentieren.

In weiterer vorteilhafter Ausgestaltung der erfindungsgemäßen Analog-Digital-Wandleranordnung kann die Logikschaltung das in mindestens einem Speicher ablegte Vergleichsergebnis auf Anforderung ausgeben. So kann die erfindungsgemäße Analog-Digital-Wandleranordnung beispielsweise eine Schnittstelleneinheit zu einem Steuergerät aufweisen, welche mindestens einen Befehl zur Durchführung des Testbetriebs und/oder zur Ausgabe des Testergebnisses vom Steuergerät empfängt und an die Logikschaltung weiterleitet. Die Schnittstelleneinheit kann den Befehl zur Durchführung des Testbetriebs bei jeder Inbetriebnahme des Gesamtsystems empfangen. Dadurch kann für jeden Betrieb der erfindungsgemäßen Analog-Digital-Wandleranordnung quasi sichergestellt werden, dass der Multiplexer fehlerfrei arbeitet.

In weiterer vorteilhafter Ausgestaltung des erfindungsgemäßen Verfahrens kann einer der Kanäle als Stimuli-Kanal und die restlichen Kanäle als Mess-Kanäle betrieben werden, wobei die einzelnen Kanäle nacheinander als Stimuli-Kanal betrieben werden können.

Ausführungsbeispiele der Erfindung sind in den Zeichnungen dargestellt und werden in der nachfolgenden Beschreibung näher erläutert. In den Zeichnungen bezeichnen gleiche Bezugszeichen Komponenten bzw. Elemente, die gleiche bzw. analoge Funktionen ausführen.

### Kurze Beschreibung der Zeichnungen

Fig. 1 zeigt ein schematisches Blockdiagramm eines Ausführungsbeispiels einer erfindungsgemäßen Analog-Digital-Wandleranordnung mit einem Multiplexer und einem Analog-Digital-Wandler.
Fig. 2 zeigt ein schematisches Schaltbild eines Kanals des Multiplexers aus Fig. 1.
Fig. 3 zeigt ein schematisches Schaltbild eines Ausschnitts der erfindungsgemäßen Analog-Digital-Wandleranordnung aus Fig. 1 mit dem Multiplexer, dem Analog-Digital-Wandler, einer Spannungsversorgung und einer Auswahleinheit.
Fig. 4 bis 11 zeigen ein schematisches Flussdiagramm eines internen Kurzschluss- und Verkopplungstests für den Multiplexer der erfindungsgemäßen Analog-Digital-Wandleranordnung aus Fig. 1 bis 3.
Fig. 12 bis 17 zeigen ein schematisches Flussdiagramm eines Verkopplungstests an den Eingangsportalen des Multiplexers der erfindungsgemäßen Analog-Digital-Wandleranordnung aus Fig. 1 bis 3.

### Ausführungsformen der Erfindung

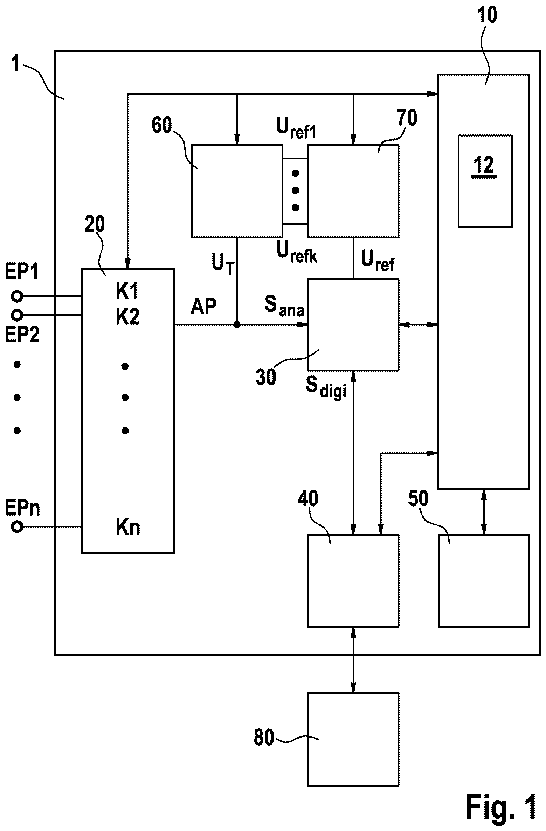

Wie aus Fig. 1 bis 3 ersichtlich ist, umfasst das dargestellte Ausführungsbeispiel einer erfindungsgemäßen Analog-Digital-Wandleranordnung 1 einen Multiplexer 20, welcher mehrere Kanäle K1 bis Kn mit mindestens einem Schalter S3, S4, S5 umfasst, eine Logikschaltung 10, welche den mindestens einen Schalter S3, S4, S5 eines jeweiligen Kanals K1 bis Kn schaltet und ein Eingangsportal EP1 bis EPn des Kanals K1 bis Kn mit einem korrespondierenden Ausgangsportal AP verbindet, und einen Analog-Digital-Wandler 30, dessen Analogeingang Sₐₙₐ mit dem Ausgangsportal AP des Multiplexer 20 verbunden ist.

Zudem ist in mindestens einem Kanal K1 bis Kn mindestens ein weiterer Schalter S1, S2, S6 zum Testen des Multiplexers 20 vorgesehen, welcher das Eingangsportal EP1 bis EPn und/oder das Ausgangsportal AP des korrespondierenden Kanals K1 bis Kn und/oder den korrespondierenden Kanal K1 bis Kn mit einem vorgegebenen Spannungspotential Uᵢₙₜ, U_{P}, Masse, U_{T} verbindet. Der mindestens eine weitere Schalter S1, S2, S6 kann vorzugsweise in einem Testbetrieb mittels einer Logikschaltung 10 geschaltet werden.

Zu diesem Zweck ist im dargestellten Ausführungsbeispiel in der Logikschaltung 10 eine Ablaufsteuerung 12 implementiert, welche während eines Testbetriebs aktiviert ist und die einzelnen Kanäle K1 bis Kn in einer vorgegebenen Reihenfolge durch Ansteuern der korrespondierenden Schalter S1, S2, S3, S4, S5, S6 dahingehend überprüft, ob der jeweilige Kanal K1 bis Kn mit einem anderen Kanal K1 bis Kn verkoppelt ist. Zusätzlich überprüft die Ablaufsteuerung 12 im dargestellten Ausführung, ob der jeweilige Kanal K1 bis Kn einen internen und/oder externen Kurzschluss zu einem anderen Spannungspotential aufweist.

Wie aus Fig. 1 weiter ersichtlich ist, umfasst die Analog-Digital-Wandleranordnung 1 eine Spannungsversorgung 70 und eine Auswahleinheit 60 zur Bereitstellung von mindestens einem vorgegebenen externen Spannungspotential U_{T}, einen Speicher 50 zum Speichern der Testergebnisse und eine Schnittstelleneinheit 40 zu einem Steuergerät 80, welche mindestens einen Befehl zur Durchführung des Testbetriebs und/oder zur Ausgabe des Testergebnisses vom Steuergerät 80 empfängt und an die Logikschaltung 10 weiterleitet. Zudem gibt die Schnittstelleneinheit 40 während des Normalbetriebs ein vom Analog-Digital-Wandler 30 am Digitalausgang S_{digi} bereitgestelltes Digitalsignal an das Steuergerät 80 aus. Die Schnittstelleneinheit 40 kann den Befehl zur Durchführung des Testbetriebs beispielsweise bei jeder Inbetriebnahme des Gesamtsystems empfangen. Die Spannungsversorgung 70 kann beispielsweise mehrere Referenzspannungspegel U_{ref1} bis U_{refk} zur Verfügung stellen, welche zum Überprüfen des Multiplexers 20 und des Analog-Digital-Wandlers 30 verwendet werden können. Die Logikschaltung 10 wählt über die Auswahleinheit 60 einen der Referenzspannungspegel U_{ref1} bis U_{refk} als Testspannung U_{T} aus und verbindet den ausgewählten Referenzspannungspegel U_{ref1} bis U_{refk} mit dem Ausgangsportal AP des Multiplexers 20 bzw. dem Analogeingang Sₐₙₐ des Analog-Digital-Wandlers 30. Gleichzeitig stellt die Spannungsversorgung 70 dem Analog-Digital-Wandler 30 eine weitere Referenzspannung U_{ref} zur Verfügung.

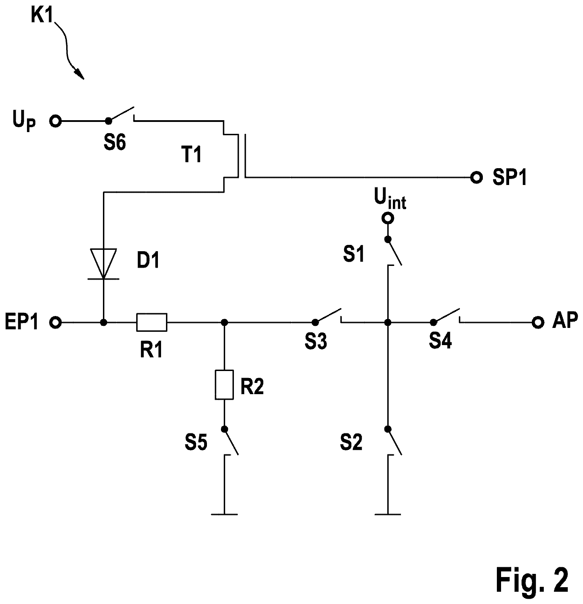

Fig. 2 zeigt beispielhaft für alle Kanäle K1 bis Kn des Multiplexers 20 einen ersten Kanal K1. Wie aus Fig. 2 weiter ersichtlich ist, umfasst der dargestellte erste Kanal K1 ein erstes Eingangsportal EP1, ein Ausgangsportal AP und mehrere Schalter S1, S2, S3, S4, S5 und S6, welche von der Logikschaltung 10 ansteuerbar sind. Über einen ersten Schalter S1 kann der erste Kanal K1 mit einem internen Spannungspotential Uᵢₙₜ verbunden werden, und über einen zweiten Schalter S2 kann der erste Kanal K1 mit einem Massepotential verbunden werden. Über einen dritten Schalter S3 und einen vierten Schalter S4 kann das erste Eingangsportal EP1 mit dem Ausgangsportal AP verbunden werden. Zur Strombegrenzung ist im dargestellten Ausführungsbeispiel ein erster Widerstand R1 in den Signalpfad zwischen dem ersten Eingangsportal EP1 und dem Ausgangsportal AP eingeschleift. Zur Signalstabilisierung kann über einen fünften Schalter S5 ein Spannungsteiler aktiviert werden, welcher neben dem ersten Widerstand R1 einen zweiten Widerstand R2 umfasst. Über einen von einem Steuerportal SP1 steuerbaren Transistor T1, einen sechsten Schalter S6 und eine Diode D1 kann das erste Eingangsportal EP1 mit einer Portversorgungsspannung U_{P} verbunden werden. Zur Verbindung des Eingangsportals EP1 mit dem Ausgangsportal AP werden die Schalter S3, S4 und S5 geschaltet bzw. geschlossen.

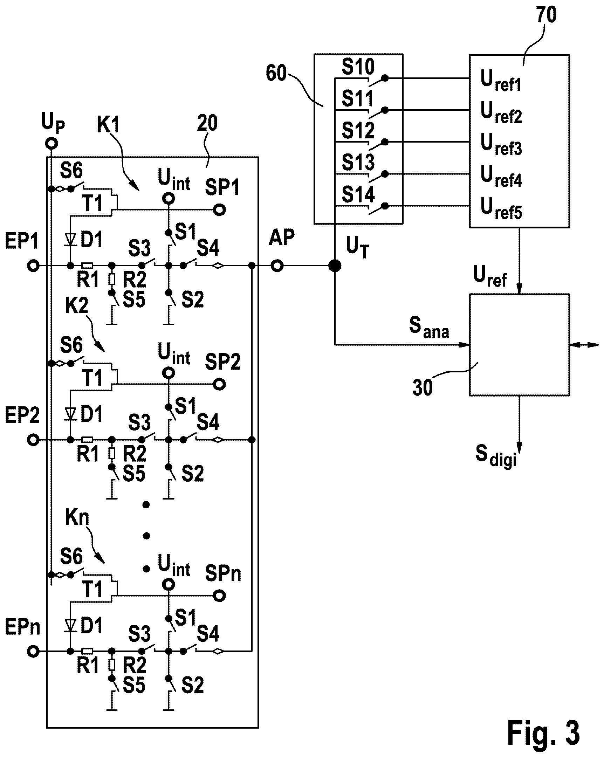

Wie aus Fig. 3 weiter ersichtlich ist, stellt die Spannungsversorgung 70 der Auswahleinheit 60 im dargestellten Ausführungsbeispiel fünf Referenzspannungspegel U_{ref1} bis U_{ref5} zur Auswahl zur Verfügung. Ein erster Referenzspannungspegel U_{ref1} entspricht beispielsweise einem Analogsignal, welches der Analog-Digital-Wandler 30 in einen maximalen digitalen Wert umwandelt. Der erste Referenzspannungspegel U_{ref1} kann von der Auswahleinheit 60 durch Schließen eines ersten Auswahlschalters S10 zu Testzwecken mit dem Ausgangsportal AP des Multiplexers 20 bzw. dem Analogeingang Sₐₙₐ des Analog-Digital-Wandlers 30 verbunden werden. Ein zweiter Referenzspannungspegel U_{ref2} entspricht beispielsweise einem Analogsignal, welches der Analog-Digital-Wandler 30 in einen digitalen Wert umwandelt, welcher etwa 75% des Maximalwerts entspricht. Der zweite Referenzspannungspegel U_{ref2} kann von der Auswahleinheit 60 durch Schließen eines zweiten Auswahlschalters S11 zu Testzwecken mit dem Ausgangsportal AP des Multiplexers 20 bzw. dem Analogeingang Sₐₙₐ des Analog-Digital-Wandlers 30 verbunden werden. Ein dritter Referenzspannungspegel U_{ref3} entspricht beispielsweise einem Analogsignal, welches der Analog-Digital-Wandler 30 in einen digitalen Wert umwandelt, welcher etwa 50% des Maximalwerts entspricht. Der dritte Referenzspannungspegel U_{ref3} kann von der Auswahleinheit 60 durch Schließen eines dritten Auswahlschalters S12 zu Testzwecken mit dem Ausgangsportal AP des Multiplexers 20 bzw. dem Analogeingang Sₐₙₐ des Analog-Digital-Wandlers 30 verbunden werden. Ein vierter Referenzspannungspegel U_{ref4} entspricht beispielsweise einem Analogsignal, welches der Analog-Digital-Wandler 30 in einen digitalen Wert umwandelt, welcher etwa 25% des Maximalwerts entspricht. Der vierte Referenzspannungspegel U_{ref4} kann von der Auswahleinheit 60 durch Schließen eines vierten Auswahlschalters S13 zu Testzwecken mit dem Ausgangsportal AP des Multiplexers 20 bzw. dem Analogeingang Sₐₙₐ des Analog-Digital-Wandlers 30 verbunden werden. Ein fünfter Referenzspannungspegel U_{ref5} entspricht beispielsweise dem Massepotential und kann von der Auswahleinheit 60 durch Schließen eines fünften Auswahlschalters S14 zu Testzwecken mit dem Ausgangsportal AP des Multiplexers 20 bzw. dem Analogeingang Sₐₙₐ des Analog-Digital-Wandlers 30 verbunden werden.

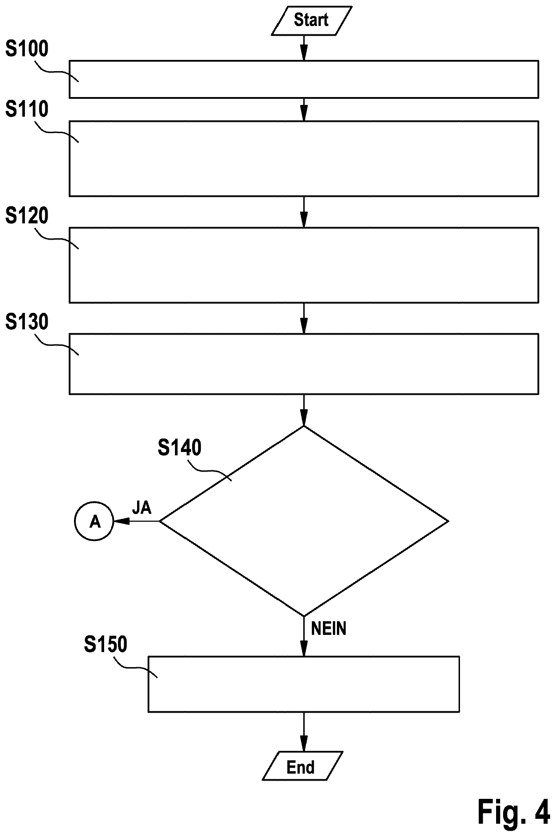

Wie aus Fig. 1 bis 3 weiter ersichtlich ist, verwendet die Logikschaltung 10 den Analog-Digital-Wandler 30 als Messelement, welches das resultierende Spannungspotential am Ausgangsportal AP des Multiplexers 20 basierend auf Kriterien ermittelt, welche von der Ablaufsteuerung 12 vorgegeben sind. Diese Kriterien können beispielsweise bestimmte Schaltzustände der Schalter S1 bis S6 im Multiplexer oder der Auswahlschalter S10 bis S14 in der Auswahleinheit 60 umfassen, wie nachfolgend unter Bezugnahme auf Fig. 4 bis 17 beschrieben wird. Die Logikschaltung 10 wertet das am Ausgangsportal AP des Multiplexers 20 ermittelte resultierende Spannungspotential basierend auf vorgegebenen Kriterien aus, welche von der Ablaufsteuerung 12 vorgegeben sind. Diese vorgegebenen Auswertekriterien können beispielsweise Schwellwerte, Wertebereiche usw. umfassen, mit welchen die ermittelten resultierenden Spannungspotentiale verglichen werden, wie nachfolgend unter Bezugnahme auf Fig. 4 bis 17 beschrieben wird. Die Logikschaltung 10 vergleicht das am Ausgangsportal AP des Multiplexers 20 ermittelte resultierende Spannungspotential mit mindestens einem vorgegebenen Schwellwert und speichert das Vergleichsergebnis im Speicher 50. Auf Anforderung gibt die Logikschaltung 10 die im Speicher 50 ablegten Vergleichsergebnisse über die Schnittstelleneinheit 40 aus.

Nachfolgend wird unter Bezugnahme auf Fig. 4 bis 11 beispielhaft ein interner Kurzschluss- und Verkopplungstests für den Multiplexer 20 der erfindungsgemäßen Analog-Digital-Wandleranordnung 1 aus Fig. 1 bis 3 beschrieben, welcher durch die implementierte Ablaufsteuerung 12 in der Logikschaltung 10 ausgeführt wird. Hierbei wird getestet ob einer der Kanäle K1 bis Kn des Multiplexers 20 einen internen Kurzschluss nach einem anderen Potential aufweist und ob mehrere Kanäle K1 bis Kn des Multiplexers 20 miteinander verkoppelt sind, was zu unbemerkten Fehlmessungen führen kann. Der Verkopplungstest läuft in zwei ineinander verschachtelten Schleifen. Man unterscheidet einen Stimuli-Kanal, der ein vorgegebenes Spannungspotential anlegt und einen Mess-Kanal, an welchem nur gemessen wird.

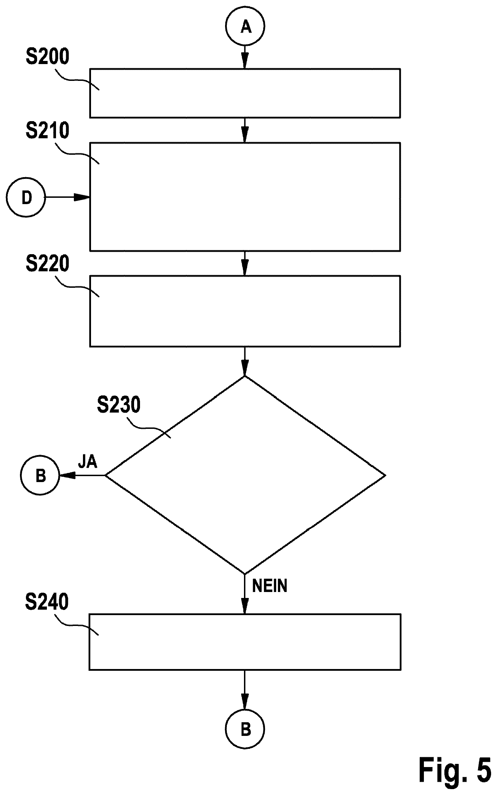

Wie aus Fig. 4 weiter ersichtlich ist, werden nach der Aktivierung des Testbetriebs im Schritt S100 alle Schalter S1 bis S6 im Multiplexer 20 und alle Auswahlschalter S10 bis S14 in der Auswahleinheit 60 geöffnet, beispielsweise durch entsprechende von der Logikschaltung 10 ausgegebenen Ansteuersignale. Im Schritt S110 werden alle Kanäle K1 bis Kn des Multiplexers 20 durch Schließen des korrespondierenden zweiten Schalters S2 mit einem internen Massepotential verbunden. Im Schritt S120 wird der zweite Auswahlschalter S11 in der Auswahleinheit 60 geschlossen, um das Ausgangsportal AP des Multiplexers 20 beispielsweise mit dem zweiten Referenzspannungspegel U_{ref2} zu verbinden. Liegt im Multiplexer 20 keine Störung vor, dann wandelt der Analog-Digital-Wandler 30 den zweiten Referenzspannungspegel U_{ref2} in ein Digitalsignal um, welches 75% des maximalen Digitalsignals entspricht. Im Schritt S130 wird das resultierende Spannungspotential U_{T} am Ausgangsportal AP des Multiplexers 20 mit dem Analog-Digital-Wandler 30 gemessen. Im Schritt S140 überprüft die Logikschaltung 10, ob das Messergebnis, d.h. das resultierende Spannungspotential U_{T} am Ausgangsportal AP des Multiplexers 20, in einem vorgegebenen ersten Wertebereich liegt. Für den ausgewählten zweiten Referenzspannungspegel U_{ref2} sollte das vom Analog-Digital-Wandler 30 ausgegebene Digitalsignal, welches das resultierende Spannungspotential am Ausgangsportal AP repräsentiert, im störungsfreien Fall beispielsweise im Bereich von 70 bis 80% des maximalen Digitalsignals liegen. Liegt das ausgegebenen Digitalsignal nicht im vorgegebenen ersten Wertebereich, d.h. das ausgegebene Digitalsignal ist niedriger als 70% des maximalen Digitalsignals, dann wird im Schritt S150 ein erster Fehler im Speicher 50 gespeichert, welcher aussagt, das in mindestens einem Kanal K1 bis Kn des Multiplexers 20 der Schalter S4 kurzgeschlossen ist. Anschließend wird der Testbetrieb beendet. Das Testergebnis kann auf Anforderung über die Schnittstelleneinheit 40 ausgegeben werden. Liegt das ausgegebene Digitalsignal im vorgegebenen ersten Wertebereich, dann verzweigt die Ablaufsteuerung 12 über einen Knotenpunkt A zum Schritt S200 in Fig. 5.

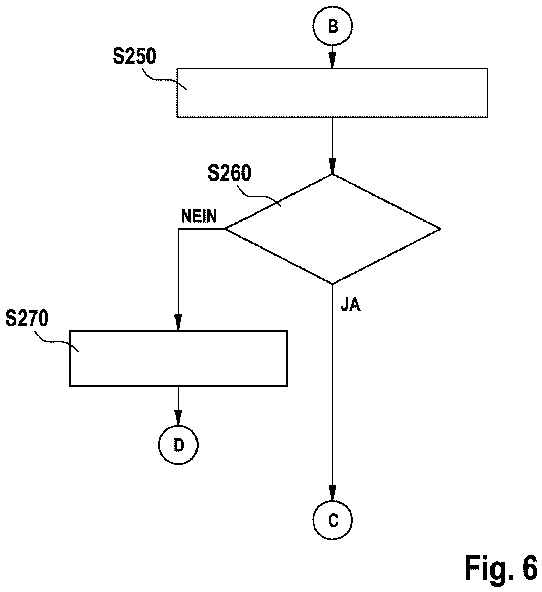

Wie aus Fig. 5 weiter ersichtlich ist, wird im Schritt S200 der erste Kanal K1 des Multiplexers 20 als Stimuli-Kanal ausgewählt. Dann wird im Schritt S210 der ausgewählte Stimuli-Kanal durch Schließen des vierten Schalters S4 mit dem Ausgangsportal AP des Multiplexers 20 verbunden und im Schritt S220 wird das resultierende Spannungspotential U_{T} am Ausgangsportal AP des Multiplexers 20 vom Analog-Digital-Wandler 30 gemessen. Da der ausgewählte Stimuli-Kanal über den zweiten Schalter S2 gleichzeitig mit dem Massepotential verbunden ist, muss sich am Ausgangsportal AP ein resultierendes Spannungspotential U_{T} ergeben, dessen korrespondierendes vom Analog-Digital-Wandler 30 ausgegebenes Digitalsignal im störungsfreien Fall deutlich niedriger als 75% des maximalen Digitalsignals ist. Im Schritt S230 überprüft die Logikschaltung 10, ob das Messergebnis, d.h. das resultierende Spannungspotential U_{T} am Ausgangsportal AP des Multiplexers 20, in einem vorgegebenen zweiten Wertebereich liegt, welcher alle Digitalsignale umfasst, welche beispielsweise niedriger als 70% des maximalen Digitalsignals sind. Liegt das ausgegebenen Digitalsignal nicht im vorgegebenen zweiten Wertebereich, d.h. das ausgegebene Digitalsignal ist höher als 70% des maximalen Digitalsignals, dann wird im Schritt S240 ein zweiter Fehler im Speicher 50 gespeichert, welcher aussagt, das im aktuellen Stimuli-Kanal der zweite Schalter S2 oder der vierte Schalter S4 defekt ist. Anschließend verzweigt die Ablaufsteuerung 12 über einen Knotenpunkt B zum Schritt S250 in Fig. 6. Liegt das ausgegebene Digitalsignal im vorgegebenen zweiten Wertebereich, dann verzweigt die Ablaufsteuerung 12 über den Knotenpunkt B direkt zum Schritt S250 in Fig. 6.

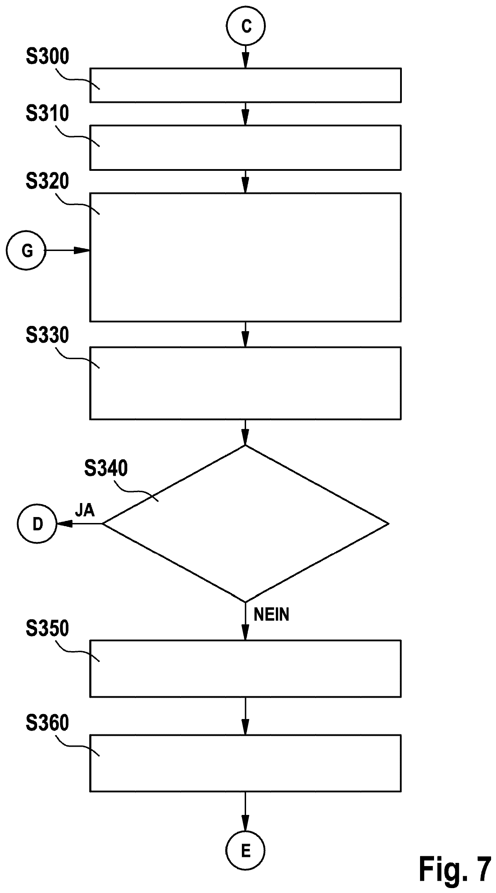

Wie aus Fig. 6 weiter ersichtlich ist, wird im Schritt S250 die Verbindung des vorgegebenen Stimuli-Kanals zum Ausgangsportal AP des Multiplexers 20 geöffnet, in dem der vierte Schalter S4 im vorgegebenen Stimuli-Kanal geöffnet wird. Die Schritte 210 bis 250 werden nacheinander für alle Kanäle K1 bis Kn des Multiplexers 20 durchgeführt. Daher wird im Schritt S260 überprüft, ob alle Kanäle K1 bis Kn des Multiplexers 20 als Stimuli-Kanal überprüft wurden. Ist dies nicht der Fall, dann wird im Schritt S270 der nächste Kanal des Multiplexers 20 als Stimuli-Kanal ausgewählt. Das bedeutet, das nach dem ersten Kanal K1, der zweite Kanal K2 usw. ausgewählt wird, bis auch der letzte Kanal Kn des Multiplexers 20 überprüft ist. Nach der Auswahl des nächsten Kanals im Schritt S270 verzweigt die Ablaufsteuerung 12 über einen Knotenpunkt D zurück zum Schritt S210 in Fig. 5 und wiederholt die Schritte S210 bis S260 für den ausgewählten Kanal. Sind alle Kanäle K1 bis Kn des Multiplexers 20 als Stimuli-Kanal überprüft worden, dann verzweigt die Ablaufsteuerung 12 über einen Knotenpunkt C zum Schritt S300 in Fig. 7.

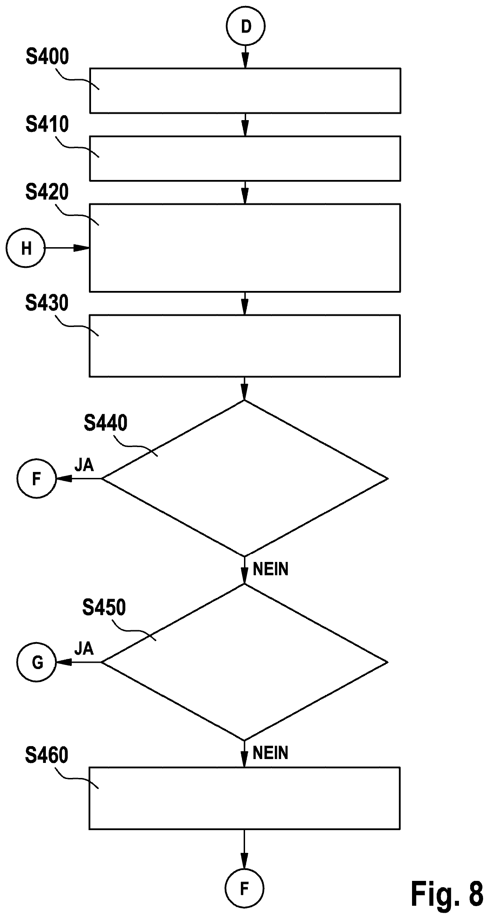

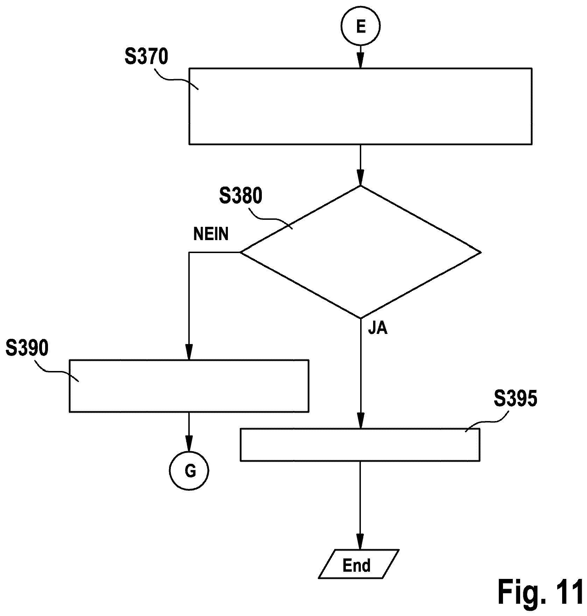

Wie aus Fig. 7 weiter ersichtlich ist, werden im Schritt S300 alle Schalter S1 bis S6 im Multiplexer 20 und alle Auswahlschalter S10 bis S14 in der Auswahleinheit 60 geöffnet. Im Schritt S310 wird der erste Kanal K1 des Multiplexers 20 als Stimuli-Kanal ausgewählt. Dann wird im Schritt S320 der ausgewählte Stimuli-Kanal durch Schließen des ersten Schalter S1 mit einem internen Spannungspotential Uᵢₙₜ, dessen Wert beispielsweise dem ersten Referenzspannungspegel U_{ref1} entspricht, und durch Schließen des vierten Schalters S4 gleichzeitig mit dem Ausgangsportal AP des Multiplexers 20 verbunden. Im Schritt S330 wird das resultierende Spannungspotential U_{T} am Ausgangsportal AP des Multiplexers 20 vom Analog-Digital-Wandler 30 gemessen. Da der ausgewählte Stimuli-Kanal über den ersten Schalter S1 gleichzeitig mit dem internen Spannungspotential Uᵢₙₜ verbunden ist, muss sich am Ausgangsportal AP ein resultierendes Spannungspotential U_{T} ergeben, dessen korrespondierendes vom Analog-Digital-Wandler 30 ausgegebenes Digitalsignal im störungsfreien Fall höher als 90% des maximalen Digitalsignals ist. Im Schritt S340 überprüft die Logikschaltung 10, ob das Messergebnis, d.h. das resultierende Spannungspotential U_{T} am Ausgangsportal AP des Multiplexers 20, in einem vorgegebenen dritten Wertebereich liegt, welcher alle Digitalsignale umfasst, welche beispielsweise höher als 90% des maximalen Digitalsignals sind. Liegt das ausgegebenen Digitalsignal nicht im vorgegebenen dritten Wertebereich, d.h. das ausgegebene Digitalsignal ist niedriger als 90% des maximalen Digitalsignals, dann wird im Schritt S350 ein dritter Fehler im Speicher 50 gespeichert, welcher aussagt, das im aktuellen Stimuli-Kanal der erste Schalter S1 oder der vierte Schalter S4 defekt ist. Treten der zweite und dritte Fehler am selben Kanal auf, dann kann der vierte Schalter S4 dieses Kanals als fehlerhaft gespeichert werden. Dann wird im Schritt S360 die Verbindung des vorgegebenen Stimuli-Kanals zum Ausgangsportal AP des Multiplexers 20 geöffnet, in dem der vierte Schalter S4 im vorgegebenen Stimuli-Kanal geöffnet wird. Anschließend verzweigt die Ablaufsteuerung 12 über einen Knotenpunkt E zum Schritt S370 in Fig. 11. Liegt das ausgegebene Digitalsignal im vorgegebenen dritten Wertebereich, dann verzweigt die Ablaufsteuerung 12 über den Knotenpunkt D zum Schritt S400 in Fig. 8.

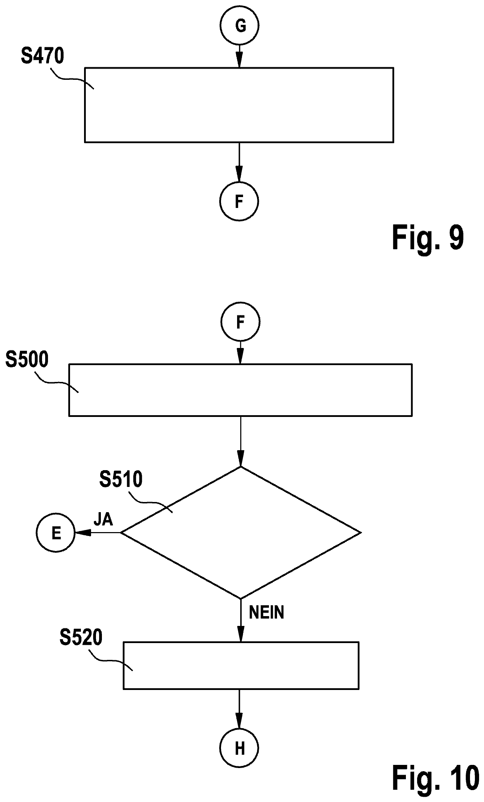

Wie aus Fig. 8 weiter ersichtlich ist, wird im Schritt S400 die Verbindung des vorgegebenen Stimuli-Kanals zum Ausgangsportal AP des Multiplexers 20 geöffnet, in dem der vierte Schalter S4 im vorgegebenen Stimuli-Kanal geöffnet wird. Im Schritt S410 wird einer der anderen Kanäle des Multiplexers 20 als Mess-Kanal ausgewählt. Dann wird im Schritt S420 der ausgewählte Mess-Kanal durch Schließen des zweiten Schalter S2 mit einem internen Massepotential und durch Schließen des vierten Schalters S4 gleichzeitig mit dem Ausgangsportal AP des Multiplexers 20 verbunden. Im Schritt S430 wird das resultierende Spannungspotential U_{T} am Ausgangsportal AP des Multiplexers 20 vom Analog-Digital-Wandler 30 gemessen. Da der ausgewählte Mess-Kanal über den zweiten Schalter S2 gleichzeitig mit dem internen Massepotential verbunden ist, muss sich am Ausgangsportal AP ein resultierendes Spannungspotential U_{T} ergeben, dessen korrespondierendes vom Analog-Digital-Wandler 30 ausgegebenes Digitalsignal im störungsfreien Fall niedriger als 20% des maximalen Digitalsignals ist. Im Schritt S440 überprüft die Logikschaltung 10, ob das Messergebnis, d.h. das resultierende Spannungspotential U_{T} am Ausgangsportal AP des Multiplexers 20, in einem vorgegebenen vierten Wertebereich liegt, welcher alle Digitalsignale umfasst, welche beispielsweise niedriger als 20% des maximalen Digitalsignals sind. Liegt das ausgegebenen Digitalsignal nicht im vorgegebenen vierten Wertebereich, d.h. das ausgegebene Digitalsignal ist höher als 20% des maximalen Digitalsignals, dann überprüft die Logikschaltung 10 im Schritt S450, ob das Messergebnis, d.h. das resultierende Spannungspotential U_{T} am Ausgangsportal AP des Multiplexers 20, in einem vorgegebenen fünften Wertebereich liegt, welcher alle Digitalsignale umfasst, welche beispielsweise höher als 30% und niedriger als 40% des maximalen Digitalsignals sind. Liegt das ausgegebenen Digitalsignal nicht im vorgegebenen fünften Wertebereich, dann wird im Schritt S460 ein fünfter Fehler im Speicher 50 gespeichert, welcher aussagt, dass im aktuellen Mess-Kanal der zweite Schalter S2 oder der vierte Schalter S4 defekt sind. Anschließend verzweigt die Ablaufsteuerung 12 über den Knotenpunkt F zum Schritt S500 in Fig. 10. Liegt das ausgegebene Digitalsignal im vorgegebenen fünften Wertebereich, dann verzweigt die Ablaufsteuerung 12 über den Knotenpunkt G zum Schritt S470 in Fig. 9. Liegt das ausgegebene Digitalsignal im vorgegebenen vierten Wertebereich, dann verzweigt die Ablaufsteuerung 12 direkt über den Knotenpunkt F zum Schritt S500 in Fig. 10.

Wie aus Fig. 9 weiter ersichtlich ist, wird im Schritt S470 ein vierter Fehler im Speicher 50 gespeichert, welcher aussagt, dass der aktuell überprüfte Mess-Kanal mit dem aktuellen Stimuli-Kanal verkoppelt ist. Anschließend verzweigt die Ablaufsteuerung 12 ebenfalls über den Knotenpunkt F zum Schritt S500 in Fig. 10.

Wie aus Fig. 10 weiter ersichtlich ist, werden im Schritt S500 alle geschlossenen Schalter, d.h. der zweite Schalter S2 und der vierte Schalter S4 des aktuellen Mess-Kanals geöffnet. Dadurch wird die Verbindung des vorgegebenen Mess-Kanals zum Ausgangsportal AP des Multiplexers 20 geöffnet und der aktuelle Mess-Kanal vom Massepotential getrennt. Die Schritte 420 bis 500 werden nacheinander für alle anderen Kanäle des Multiplexers 20, außer dem aktuellen Stimuli-Kanal durchgeführt. Daher wird im Schritt S510 überprüft, ob alle anderen Kanäle des Multiplexers 20 als Mess-Kanal überprüft wurden. Ist dies nicht der Fall, dann wird im Schritt S520 der nächste Kanal des Multiplexers 20 als Mess-Kanal ausgewählt. Ist beispielsweise der erste Kanal K1 als Stimuli-Kanal ausgewählt, dann wird nach dem zweiten Kanal K2, ein dritter Kanal K3 usw. als Mess-Kanal ausgewählt, bis auch der letzte Kanal Kn des Multiplexers 20 als Mess-Kanal bei einem ersten Kanal K1 als Stimuli-Kanal überprüft ist. Nach der Auswahl des nächsten Mess-Kanals im Schritt S520 verzweigt die Ablaufsteuerung 12 über einen Knotenpunkt H zurück zum Schritt S420 in Fig. 8 und wiederholt die Schritte S420 bis S440 für den ausgewählten Mess-Kanal. Sind alle anderen Kanäle des Multiplexers 20 für den vorgegebenen Stimuli-Kanal als Mess-Kanal überprüft worden, dann verzweigt die Ablaufsteuerung 12 über einen Knotenpunkt E zum Schritt S370 in Fig. 11.

Wie aus Fig. 11 weiter ersichtlich ist, wird im Schritt S370 die Verbindung des vorgegebenen Stimuli-Kanals zum internen Spannungspotential Uᵢₙₜ des Multiplexers 20 geöffnet, in dem der erste Schalter S1 im vorgegebenen Stimuli-Kanal geöffnet wird. Die Schritte S220 bis S370 werden nacheinander für alle Kanäle K1 bis Kn des Multiplexers 20 durchgeführt. Daher wird im Schritt S380 überprüft, ob alle Kanäle K1 bis Kn des Multiplexers 20 als Stimuli-Kanal überprüft wurden. Ist dies nicht der Fall, dann wird im Schritt S390 der nächste Kanal des Multiplexers 20 als Stimuli-Kanal ausgewählt. Das bedeutet, das nach dem ersten Kanal K1, der zweite Kanal K2 usw. ausgewählt wird, bis auch der letzte Kanal Kn des Multiplexers 20 als Stimuli-Kanal überprüft ist. Nach der Auswahl des nächsten Stimuli-Kanals im Schritt S390 verzweigt die Ablaufsteuerung 12 über einen Knotenpunkt G zurück zum Schritt S320 in Fig. 7 und wiederholt die Schritte S320 bis S370 für den ausgewählten Stimuli-Kanal. Sind alle Kanäle K1 bis Kn des Multiplexers 20 als Stimuli-Kanal überprüft worden, dann werden im Schritt S395 alle Schalter S1 bis S6 im Multiplexer 20 und alle Auswahlschalter S10 bis S14 in der Auswahleinheit 60 geöffnet und die Ablaufsteuerung 12 beendet die internen Kurzschluss- und Verkopplungstests. Die Ergebnisse der internen Kurzschluss- und Verkopplungstests sind im Speicher 50 gespeichert und können auf Anforderung über die Schnittstelleneinheit 40 ausgegeben. Neben den beschriebenen Fehlerzuständen können auch fehlerfreie Messergebnisse im Speicher 50 gespeichert werden.

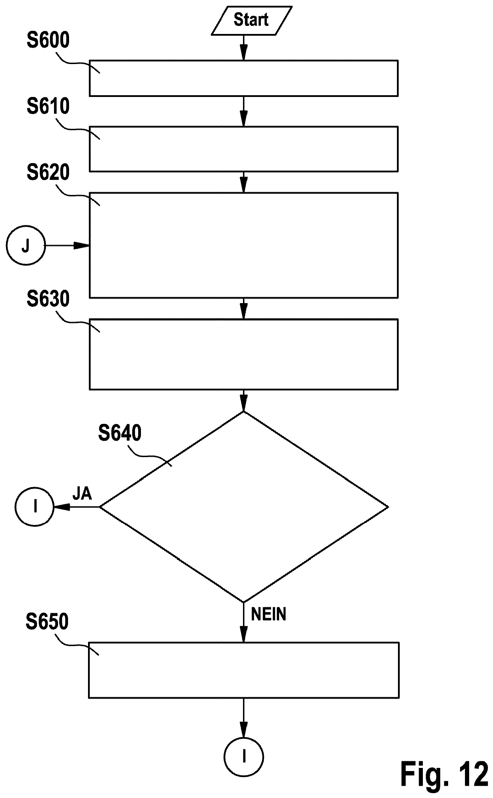

Nachfolgend wird unter Bezugnahme auf Fig. 12 bis 17 beispielhaft ein Verkopplungstest an den Eingangsportalen EP1 bis EPn des Multiplexers 20 der erfindungsgemäßen Analog-Digital-Wandleranordnung 1 aus Fig. 1 bis 3 beschrieben. Hierbei kann über den sechsten Schalter S6 ein internes Portspannungspotential Up am Eingangsportal EP1 bis EPn des korrespondierenden Kanals K1 bis Kn des Multiplexers 20 ausgegeben werden. Das interne Portspannungspotential Up kann beispielsweise dem dritten Referenzspannungspegel U_{ref3} entsprechen. Analog zur internen Verkopplungsmessung kann nun nach externen Verkopplungen zwischen den Kanälen K1 bis Kn des Multiplexers 20 gesucht werden. Der Test läuft ebenfalls in zwei ineinander verschachtelten Schleifen ab, wobei ein Stimuli-Kanal das interne Portspannungspotential U_{P} über den sechsten Schalter S6 anlegt.

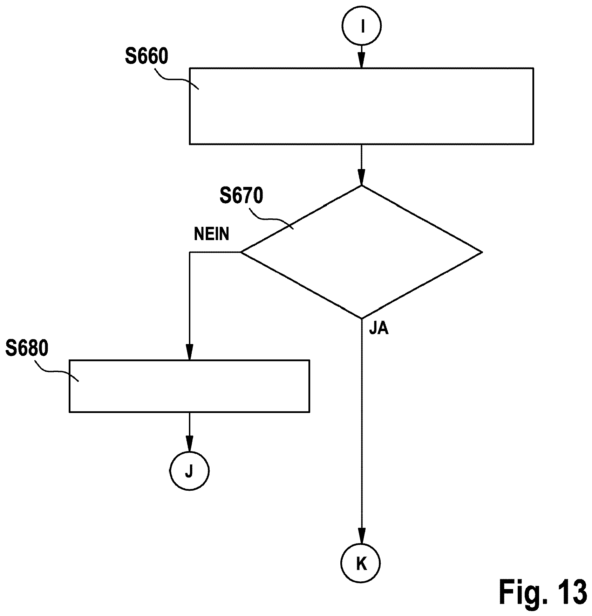

Wie aus Fig. 12 weiter ersichtlich ist, werden im Schritt S600 alle Schalter S1 bis S6 im Multiplexer 20 und alle Auswahlschalter S10 bis S14 in der Auswahleinheit 60 geöffnet. Im Schritt S610 wird der erste Kanal K1 des Multiplexers 20 als Stimuli-Kanal ausgewählt. Dann wird im Schritt S620 das Eingangsportal EP1 bis EPn des ausgewählten Stimuli-Kanals durch Schließen der Schalter S3, S4, S5 mit dem Ausgangsportal AP des Multiplexers 20 verbunden. Im Schritt S630 wird das resultierende Spannungspotential U_{T} am Ausgangsportal AP des Multiplexers 20 vom Analog-Digital-Wandler 30 gemessen. Da der ausgewählte Stimuli-Kanal über den fünften Schalter S5 über den Widerstand R2 gleichzeitig mit dem internen Massepotential verbunden ist, muss sich am Ausgangsportal AP ein resultierendes Spannungspotential U_{T} ergeben, dessen korrespondierendes vom Analog-Digital-Wandler 30 ausgegebenes Digitalsignal im störungsfreien Fall niedriger als 40% des maximalen Digitalsignals ist. Im Schritt S640 überprüft die Logikschaltung 10, ob das Messergebnis, d.h. das resultierende Spannungspotential U_{T} am Ausgangsportal AP des Multiplexers 20, in einem vorgegebenen sechsten Wertebereich liegt, welcher alle Digitalsignale umfasst, welche beispielsweise niedriger als 40% des maximalen Digitalsignals sind. Liegt das ausgegebenen Digitalsignal nicht im vorgegebenen sechsten Wertebereich, d.h. das ausgegebene Digitalsignal ist höher als 40% des maximalen Digitalsignals, dann wird im Schritt S650 ein sechster Fehler im Speicher 50 gespeichert, welcher aussagt, das der aktuelle Stimuli-Kanal einen Kurzschluss zu einem Spannungspotential aufweist. Anschließend verzweigt die Ablaufsteuerung 12 über einen Knotenpunkt I zum Schritt S660 in Fig. 13. Liegt das ausgegebene Digitalsignal im vorgegebenen sechsten Wertebereich, dann verzweigt die Ablaufsteuerung 12 direkt über den Knotenpunkt I zum Schritt S660 in Fig. 13.

Wie aus Fig. 13 weiter ersichtlich ist, werden im Schritt S660 alle geschlossenen Schalter, d.h. der dritte Schalter S3, der vierte Schalter S4 und der fünfte Schalter S5 des aktuellen Stimuli-Kanals geöffnet. Dadurch wird die Verbindung des Eingangsportals EP1 bis EPn des vorgegebenen Stimuli-Kanals wieder vom Ausgangsportal AP des Multiplexers 20 getrennt. Die Schritte 620 bis 660 werden nacheinander für alle Kanäle K1 bis Kn des Multiplexers 20 durchgeführt.

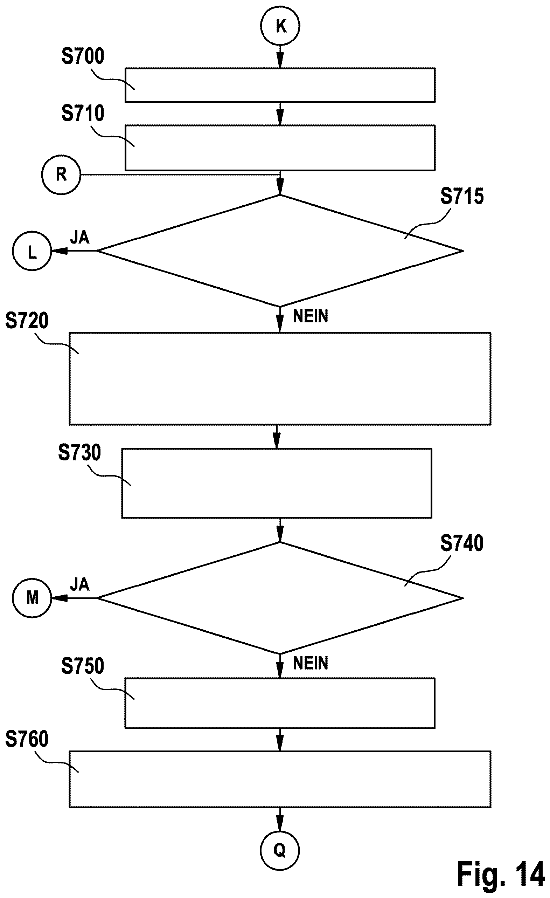

Daher wird im Schritt S670 überprüft, ob alle Kanäle K1 bis Kn des Multiplexers 20 als Stimuli-Kanal überprüft wurden. Ist dies nicht der Fall, dann wird im Schritt S680 der nächste Kanal des Multiplexers 20 als Stimuli-Kanal ausgewählt. Nach der Auswahl des nächsten Stimuli-Kanals im Schritt S680 verzweigt die Ablaufsteuerung 12 über einen Knotenpunkt J zurück zum Schritt S620 in Fig. 12 und wiederholt die Schritte S620 bis S660 für den ausgewählten Stimuli-Kanal. Sind alle Kanäle K1 bis Kn des Multiplexers 20 als Stimuli-Kanal überprüft worden, dann verzweigt die Ablaufsteuerung 12 über einen Knotenpunkt K zum Schritt S700 in Fig. 14.

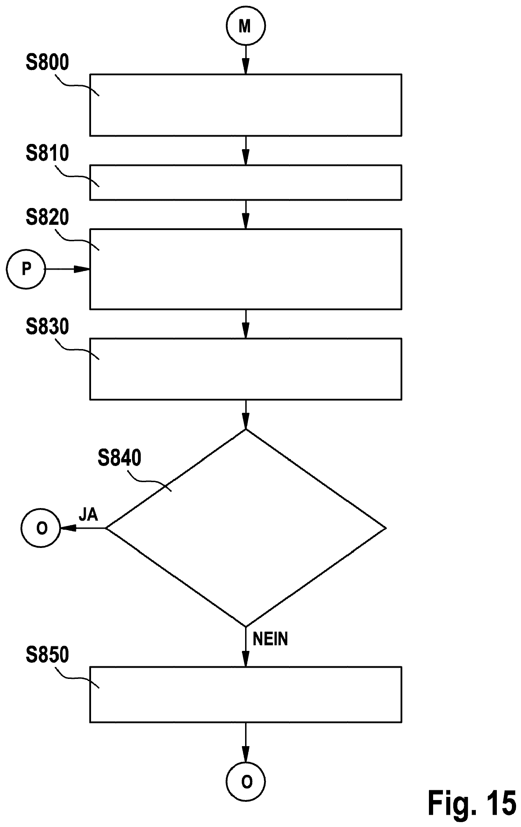

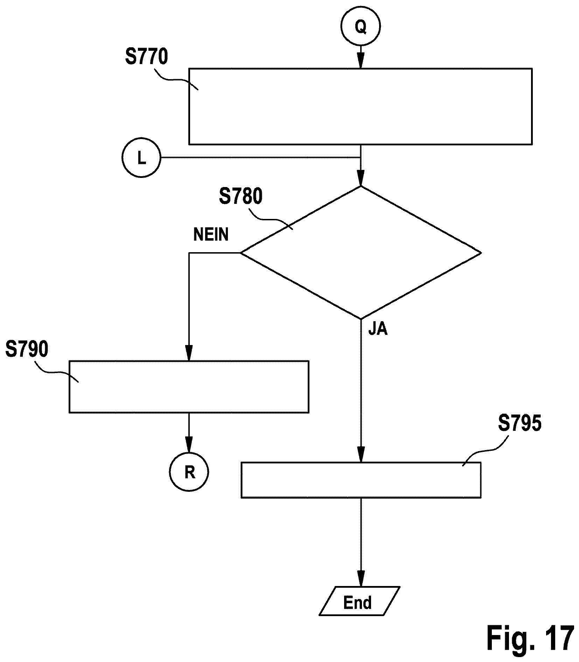

Wie aus Fig. 14 weiter ersichtlich ist, werden im Schritt S700 alle Schalter S1 bis S6 im Multiplexer 20 und alle Auswahlschalter S10 bis S14 in der Auswahleinheit 60 geöffnet. Im Schritt S710 wird der erste Kanal K1 des Multiplexers 20 als Stimuli-Kanal ausgewählt. Dann wird im Schritt S715 überprüft, ob der ausgewählte Stimuli-Kanal einen Kurzschluss zu einem Spannungspotential, d.h. den sechsten Fehler aufweist. Weist der Stimuli-Kanal den sechsten Fehler auf, dann verzweigt die Ablaufsteuerung 12 über einen Knotenpunkt L zum Schritt S780 in Fig. 17. Weist der Stimuli-Kanal den sechsten Fehler nicht auf, dann wird im Schritt S720 das Eingangsportal EP1 bis EPn des ausgewählten Stimuli-Kanals durch Schließen der Schalter S3, S4, S5 mit dem Ausgangsportal AP des Multiplexers 20 verbunden. Gleichzeitig wird das Eingangsportal EP1 bis EPn des ausgewählten Stimuli-Kanals durch Schließen des sechsten Schalter S6 mit dem Portspannungspotential U_{P} verbunden, dessen Wert beispielsweise dem dritten Referenzspannungspegel U_{ref3} entspricht. Im Schritt S730 wird das resultierende Spannungspotential U_{T} am Ausgangsportal AP des Multiplexers 20 vom Analog-Digital-Wandler 30 gemessen. Da das Portspannungspotential U_{P} etwa 50% des maximalen Digitalsignals entspricht, muss sich am Ausgangsportal AP ein resultierendes Spannungspotential U_{T} ergeben, dessen korrespondierendes vom Analog-Digital-Wandler 30 ausgegebenes Digitalsignal im störungsfreien Fall höher als 40% des maximalen Digitalsignals ist. Im Schritt S740 überprüft die Logikschaltung 10, ob das Messergebnis, d.h. das resultierende Spannungspotential U_{T} am Ausgangsportal AP des Multiplexers 20, in einem vorgegebenen siebten Wertebereich liegt, welcher alle Digitalsignale umfasst, welche beispielsweise höher als 40% des maximalen Digitalsignals sind. Liegt das ausgegebenen Digitalsignal nicht im vorgegebenen dritten Wertebereich, d.h. das ausgegebene Digitalsignal ist niedriger als 40% des maximalen Digitalsignals, dann wird im Schritt S750 ein siebter Fehler im Speicher 50 gespeichert, welcher aussagt, dass der aktuelle Stimuli-Kanal einen Kurzschluss nach Masse aufweist. Dann wird im Schritt S760 die Verbindung des Eingangsportal EP1 bis EPn des vorgegebenen Stimuli-Kanals zum Ausgangsportal AP des Multiplexers 20 geöffnet, in dem die Schalter S3, S4 und S5 im vorgegebenen Stimuli-Kanal geöffnet werden. Anschließend verzweigt die Ablaufsteuerung 12 über einen Knotenpunkt Q zum Schritt S770 in Fig. 17. Liegt das ausgegebene Digitalsignal im vorgegebenen siebten Wertebereich, dann verzweigt die Ablaufsteuerung 12 über den Knotenpunkt M zum Schritt S800 in Fig. 15.

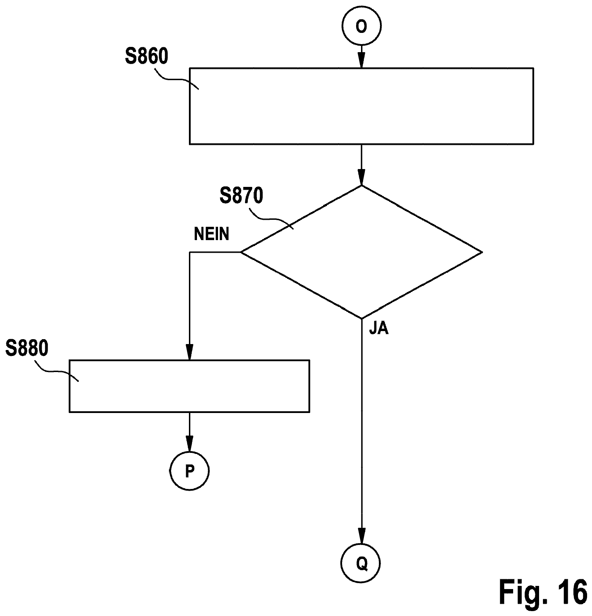

Wie aus Fig. 15 weiter ersichtlich ist, wird im Schritt S800 die Verbindung des Eingangsportal EP1 bis EPn des vorgegebenen Stimuli-Kanals zum Ausgangsportal AP des Multiplexers 20 geöffnet, in dem die Schalter S3, S4 und S5 im vorgegebenen Stimuli-Kanal geöffnet werden. Im Schritt S810 wird einer der anderen Kanäle des Multiplexers 20 als Mess-Kanal ausgewählt. Dann wird im Schritt S820 das Eingangsportal EP1 bis EPn des ausgewählten Mess-Kanals durch Schließen der Schalter S3, S4, S5 mit dem Ausgangsportal AP des Multiplexers 20 verbunden. Im Schritt S830 wird das resultierende Spannungspotential U_{T} am Ausgangsportal AP des Multiplexers 20 vom Analog-Digital-Wandler 30 gemessen. Da der ausgewählte Mess-Kanal über den fünften Schalter S5 über den Widerstand R2 gleichzeitig mit dem internen Massepotential verbunden ist, muss sich am Ausgangsportal AP ein resultierendes Spannungspotential U_{T} ergeben, dessen korrespondierendes vom Analog-Digital-Wandler 30 ausgegebenes Digitalsignal im störungsfreien Fall niedriger als 40% des maximalen Digitalsignals ist. Im Schritt S840 überprüft die Logikschaltung 10, ob das Messergebnis, d.h. das resultierende Spannungspotential U_{T} am Ausgangsportal AP des Multiplexers 20, in einem vorgegebenen achten Wertebereich liegt, welcher alle Digitalsignale umfasst, welche beispielsweise niedriger als 40% des maximalen Digitalsignals sind. Liegt das ausgegebenen Digitalsignal nicht im vorgegebenen achten Wertebereich, d.h. das ausgegebene Digitalsignal ist höher als 40% des maximalen Digitalsignals, dann wird im Schritt S850 ein achter Fehler im Speicher 50 gespeichert, welcher aussagt, das der aktuellen Mess-Kanal mit dem aktuellen Stimuli-Kanal verkoppelt ist. Anschließend verzweigt die Ablaufsteuerung 12 über den Knotenpunkt O zum Schritt S860 in Fig. 16. Liegt das ausgegebenen Digitalsignal im vorgegebenen achten Wertebereich, dann verzweigt die Ablaufsteuerung 12 direkt über den Knotenpunkt O zum Schritt S860 in Fig. 16.

Wie aus Fig. 16 weiter ersichtlich ist, werden im Schritt S860 alle geschlossenen Schalter, d.h. der dritte Schalter S3, der vierte Schalter S4 und der fünfte Schalter S5 des aktuellen Mess-Kanals geöffnet. Dadurch wird die Verbindung des Eingangsportals EP1 bis EPn des vorgegebenen Mess-Kanals zum Ausgangsportal AP des Multiplexers 20 geöffnet. Die Schritte 820 bis 860 werden nacheinander für alle anderen Kanäle des Multiplexers 20, außer dem aktuellen Stimuli-Kanal durchgeführt. Daher wird im Schritt S870 überprüft, ob alle anderen Kanäle des Multiplexers 20 als Mess-Kanal überprüft wurden. Ist dies nicht der Fall, dann wird im Schritt S880 der nächste Kanal des Multiplexers 20 als Mess-Kanal ausgewählt. Nach der Auswahl des nächsten Mess-Kanals im Schritt S880 verzweigt die Ablaufsteuerung 12 über einen Knotenpunkt P zurück zum Schritt S820 in Fig. 15 und wiederholt die Schritte S820 bis S860 für den ausgewählten Mess-Kanal. Sind alle anderen Kanäle des Multiplexers 20 für den vorgegebenen Stimuli-Kanal als Mess-Kanal überprüft worden, dann verzweigt die Ablaufsteuerung 12 über einen Knotenpunkt Q zum Schritt S770 in Fig. 17.

Wie aus Fig. 17 weiter ersichtlich ist, wird im Schritt S770 die Verbindung des Eingangsportals EP1 bis EPn des vorgegebenen Stimuli-Kanals zum internen Portspannungspotential U_{P} des Multiplexers 20 geöffnet, in dem der sechste Schalter S6 im vorgegebenen Stimuli-Kanal geöffnet wird. Die Schritte S715 bis S370 werden nacheinander für alle Kanäle K1 bis Kn des Multiplexers 20 durchgeführt. Daher wird im Schritt S780 überprüft, ob alle Kanäle K1 bis Kn des Multiplexers 20 als Stimuli-Kanal überprüft wurden. Ist dies nicht der Fall, dann wird im Schritt S790 der nächste Kanal des Multiplexers 20 als Stimuli-Kanal ausgewählt. Nach der Auswahl des nächsten Stimuli-Kanals im Schritt S790 verzweigt die Ablaufsteuerung 12 über einen Knotenpunkt R zurück zum Schritt S715 in Fig. 14 und wiederholt die Schritte S715 bis S770 für den ausgewählten Stimuli-Kanal. Sind alle Kanäle K1 bis Kn des Multiplexers 20 als Stimuli-Kanal überprüft worden, dann werden im Schritt S795 alle Schalter S1 bis S6 im Multiplexer 20 und alle Auswahlschalter S10 bis S14 in der Auswahleinheit 60 geöffnet und die Ablaufsteuerung 12 beendet die Verkopplungstests an den Eingangsportalen EP1 bis EPn des Multiplexers 20. Die Ergebnisse der Verkopplungstest an den Eingangsportalen EP1 bis EPn des Multiplexers 20 sind im Speicher 50 gespeichert und können auf Anforderung über die Schnittstelleneinheit 40 ausgegeben. Neben den beschriebenen Fehlerzuständen können auch fehlerfreie Messergebnisse im Speicher 50 gespeichert werden.

Da alle Tests automatisch nach dem Starten durch die Software automatisch ablaufen, ist das Steuergerät bzw. ein Mikrocontroller im Steuergerät vom Testbetrieb der Analog-Digital-Wandleranordnung 1 unbeeinflusst und kann in dieser Zeit andere Prozesse bearbeiten. Nach Beendigung des automatischen Testbetriebs können die Messergebnisse bei Bedarf abgeholt werden.

Ausführungsformen der vorliegenden Erfindung stellen eine Analog-Digital-Wandleranordnung und ein Verfahren zur Überprüfung eines Multiplexers für einen Analog-Digital-Wandler zur Verfügung, welche mögliche Fehler im Multiplexer, wie beispielsweise Kurzschlüsse zu einem anderen Potential, eine Verkopplung mehrerer Kanäle untereinander oder eine Unterbrechung des Kanals während eines automatischen Testbetriebs erkennen können, so dass die erfindungsgemäße Analog-Digital-Wandleranordnung zur Erfassung bzw. Messung und Verarbeitung von sicherheitsrelevanten Größen eingesetzt werden kann. Der automatische Testbetrieb kann über einen Softwarebefehl aktiviert werden, welche die automatisch ablaufende Ablaufsteuerung empfängt, welche die einzelnen Testbedingungen aktiviert und auswertet. Das Ergebnis der Überprüfung kann dann über einen entsprechenden Softwarebefehl angefordert werden.

## Patentansprüche

1. Analog-Digital-Wandleranordnung mit einem Multiplexer (20), welcher ein Ausgangsportal (AP) und mehrere Kanäle (K1 bis Kn) mit mindestens einem Schalter (S3, S4, S5) und mit mindestens einem Widerstand (R1) umfasst, wobei der mindestens eine Schalter (S3, S4, S5) ein Eingangsportal (EP1 bis EPn) des Kanals (K1 bis Kn) mit dem Ausgangsportal (AP) verbindet, und einem Analog-Digital-Wandler (30), dessen Analogeingang (Sₐₙₐ) mit dem Ausgangsportal (AP) verbunden ist, wobei in mindestens einem der mehreren Kanäle (K1 bis Kn) mindestens ein weiterer Schalter (S1, S2, S6) zum Testen des Multiplexers (20) vorgesehen ist, welcher das Eingangsportal (EP1 bis EPn) des mindestens einen Kanals (K1 bis Kn) und/oder das Ausgangsportal (AP) und/oder den mindestens einen Kanal (K1 bis Kn) mit einem vorgegebenen Spannungspotential (Uᵢₙₜ, U_{P}, Masse) verbindet, wobei eine Logikschaltung (10) vorgesehen ist, welche den mindestens einen Schalter (S3, S4, S5) und den mindestens einen weiteren Schalter (S1, S2, S6) schaltet, wobei in der Logikschaltung (10) eine Ablaufsteuerung (12) derart implementiert ist, dass die korrespondierenden Schalter (S1, S2, S3, S4, S5, S6) der einzelnen Kanäle (K1 bis Kn) in einer vorgegebenen Reihenfolge angesteuert werden, um zu überprüfen, ob der jeweilige Kanal (K1 bis Kn) mit einem anderen Kanal (K1 bis Kn) verkoppelt ist, wobei die Logikschaltung (10) in der Analog-Digital-Wandleranordnung vorgesehen ist **dadurch gekennzeichnet, dass**
der Multiplexer (20) einen ersten weiteren Schalter (S1) aufweist, welcher den Kanal (K1 bis Kn) mit einem internen Spannungspotential (Uᵢₙₜ) verbindet, einen zweiten weiteren Schalter (S2) aufweist, welcher den Kanal (K1 bis Kn) direkt mit dem Massepotential (Masse) verbindet und einen dritten weiteren Schalter (S6) aufweist, welcher das Eingangsportal (EP1 bis EPn) des mindestens einen Kanals (K1 bis Kn) über eine Diode (D1) und über einen von einem Steuerportal (SP1) steuerbaren Transistor (T1) mit einer Portversorgungsspannung (U_{P}) verbindet.

2. Analog-Digital-Wandleranordnung nach Anspruch 1 wobei die Ablaufsteuerung (12) überprüft, ob der jeweilige Kanal (K1 bis Kn) einen internen und/oder externen Kurzschluss zu einem anderen Spannungspotential aufweist.

3. Analog-Digital-Wandleranordnung nach Anspruch 2, wobei der mindestens eine weitere Schalter (S1, S2, S6) in einem Testbetrieb schaltbar ist und die Ablaufsteuerung (12) in der Logikschaltung (10) während des Testbetriebs aktiviert ist.

4. Analog-Digital-Wandleranordnung nach einem der Ansprüche 1 bis 3, wobei eine Spannungsversorgung (70) und eine Auswahleinheit (60) vorgesehen sind zur Bereitstellung von mindestens einem vorgegebenen externen Spannungspotential (U_{T}).

5. Analog-Digital-Wandleranordnung nach einem der Ansprüche 1 bis 4, wobei die Logikschaltung (10) den Analog-Digital-Wandler (30) als Messelement verwendet, welches das resultierende Spannungspotential am Ausgangsportal (AP) des Multiplexers (20) basierend auf Kriterien ermittelt, welche von der Ablaufsteuerung (12) vorgegeben sind.

6. Analog-Digital-Wandleranordnung nach Anspruch 5, wobei die Logikschaltung (10) das am Ausgangsportal (AP) des Multiplexers (20) ermittelte resultierende Spannungspotential basierend auf vorgegebenen Kriterien auswertet, welche von der Ablaufsteuerung (12) vorgegeben sind.

7. Analog-Digital-Wandleranordnung nach Anspruch wobei die Logikschaltung (10) das am Ausgangsportal (AP) des Multiplexers (20) ermittelte resultierende Spannungspotential mit mindestens einem vorgegebenen Schwellwert vergleicht und das Vergleichsergebnis in mindestens einem Speicher (50) ablegt.

8. Analog-Digital-Wandleranordnung nach Anspruch 7, wobei die Logikschaltung (10) das in mindestens einem Speicher (50) ablegte Vergleichsergebnis auf Anforderung ausgibt.

9. Analog-Digital-Wandleranordnung nach einem der Ansprüche 1 bis 8, wobei eine Schnittstelleneinheit (40) zu einem Steuergerät (80) vorhanden ist, welche mindestens einen Befehl zur Durchführung des Testbetriebs und/oder zur Ausgabe des Testergebnisses vom Steuergerät (80) empfängt und an die Logikschaltung (10) weiterleitet.

10. Analog-Digital-Wandleranordnung nach Anspruch 9, wobei die Schnittstelleneinheit (40) den Befehl zur Durchführung des Testbetriebs bei jeder Inbetriebnahme des Gesamtsystems empfängt.

11. Verfahren zur Überprüfung eines Multiplexers für einen Analog-Digital-Wandler, wobei der Multiplexer (20) ein Ausgangsportal (AP) und mehrere Kanäle (K1 bis Kn) mit mindestens einem Widerstand (R1) und mit mindestens einem Schalter (S3, S4, S5) umfasst, wobei der mindestens eine Schalter (S3, S4, S5) ein Eingangsportal (EP1 bis EPn) des Kanals (K1 bis Kn) mit dem Ausgangsportal (AP) verbindet, und einem Analog-Digital-Wandler (30), dessen Analogeingang (Sₐₙₐ) mit dem Ausgangsportal (AP) verbunden ist, wobei in mindestens einem der mehreren Kanäle (K1 bis Kn) mindestens ein weiterer Schalter (S1, S2, S6) zum Testen des Multiplexers (20) vorgesehen ist, welcher das Eingangsportal (EP1 bis EPn) des mindestens einen Kanals (K1 bis Kn) und/oder das Ausgangsportal (AP) und/oder den mindestens einen Kanal (K1 bis Kn) mit einem vorgegebenen Spannungspotential (Uᵢₙₜ, U_{P}, Masse) verbindet, wobei der Multiplexer (20) einen ersten weiteren Schalter (S1) aufweist, welcher den Kanal (K1 bis Kn) mit einem internen Spannungspotential (Uᵢₙₜ) verbindet, einen zweiten weiteren Schalter (S2) aufweist, welcher den Kanal (K1 bis Kn) direkt mit dem Massepotential (Masse) verbindet und einen dritten weiteren Schalter (S6) aufweist, welcher das Eingangsportal (EP1 bis EPn) des mindestens einen Kanals (K1 bis Kn) über eine Diode (D1) und über einen von einem Steuerportal (SP1) steuerbaren Transistors (T1) mit einer Portversorgungsspannung (U_{P}) verbindet, wobei eine Logikschaltung (10) vorgesehen ist, welche den mindestens einen Schalter (S3, S4, S5) und den mindestens einen weiteren Schalter (S1, S2, S6) schaltet, wobei nach einer in der Logikschaltung (10) implementierten Ablaufsteuerung (12) die korrespondierenden Schalter (S1, S2, S3, S4, S5, S6) der einzelnen Kanäle (K1 bis Kn) in einer vorgegeben Reihenfolge geschaltet werden, um zu überprüfen, ob der jeweilige Kanal (K1 bis Kn) mit einem anderen Kanal (K1 bis Kn) verkoppelt ist, wobei die Logikschaltung (10) in der Analog-Digital-Wandleranordnung vorgesehen ist.

12. Verfahren nach Anspruch 11, wobei die Ablaufsteuerung (12) überprüft, ob der jeweilige Kanal (K1 bis Kn) einen internen und/oder externen Kurzschluss zu einem anderen Spannungspotential aufweist.

13. Verfahren nach Anspruch 12, wobei der mindestens eine weitere Schalter (S1, S2, S6) in einem Testbetrieb geschaltet wird, und die Ablaufsteuerung (12) während des Testbetriebs aktiviert wird.

14. Verfahren nach einem der Ansprüche 11 bis 13, wobei einer der Kanäle (K1 bis Kn) als Stimuli-Kanal und die restlichen Kanäle (K1 bis Kn) als Mess-Kanäle betrieben werden, wobei die einzelnen Kanäle (K1 bis Kn) nacheinander als Stimuli-Kanal betrieben werden. Eingereicht in der mündlichen Verhandlung am 15. Juni 2020, 11:45 Uhr.

## Claims

1. Analogue/digital converter arrangement having a multiplexer (20), which comprises an output portal (AP) and a plurality of channels (K1 to Kn) with at least one switch (S3, S4, S5) and with at least one resistor (R1), wherein the at least one switch (S3, S4, S5) connects an input portal (EP1 to EPn) of the channel (K1 to Kn) to the output portal (AP), and having an analogue/digital converter (30), the analogue input (Sₐₙₐ) of which is connected to the output portal (AP), wherein at least one further switch (S1, S2, S6) for testing the multiplexer (20) is provided in at least one of the plurality of channels (K1 to Kn), which further switch connects the input portal (EP1 to EPn) of the at least one channel (K1 to Kn) and/or the output portal (AP) and/or the at least one channel (K1 to Kn) to a predefined voltage potential (Uᵢₙₜ, U_{P}, earth), wherein a logic circuit (10) is provided and switches the at least one switch (S3, S4, S5) and the at least one further switch (S1, S2, S6), wherein a sequence controller (12) is implemented in the logic circuit (10) in such a manner that the corresponding switches (S1, S2, S3, S4, S5, S6) of the individual channels (K1 to Kn) are actuated in a predefined order in order to check whether the respective channel (K1 to Kn) is coupled to another channel (K1 to Kn), wherein the logic circuit (10) is provided in the analogue/digital converter arrangement,
**characterized in that**
the multiplexer (20) has a first further switch (S1) which connects the channel (K1 to Kn) to an internal voltage potential (Uᵢₙₜ), a second further switch (S2) which directly connects the channel (K1 to Kn) to the earth potential (earth) and a third further switch (S6) which connects the input portal (EP1 to EPn) of the at least one channel (K1 to Kn) to a port supply voltage (U_{P}) via a diode (D1) and via a transistor (T1) which can be controlled by a control portal (SP1).

2. Analogue/digital converter arrangement according to Claim 1, wherein the sequence controller (12) checks whether the respective channel (K1 to Kn) has an internal and/or external short circuit to another voltage potential.

3. Analogue/digital converter arrangement according to Claim 2, wherein the at least one further switch (S1, S2, S6) can be switched to a test mode and the sequence controller (12) in the logic circuit (10) is activated during the test mode.

4. Analogue/digital converter arrangement according to one of Claims 1 to 3, wherein a voltage supply (70) and a selection unit (60) are provided in order to provide at least one predefined external voltage potential (U_{T}).

5. Analogue/digital converter arrangement according to one of Claims 1 to 4, wherein the logic circuit (10) uses the analogue/digital converter (30) as a measurement element which determines the resulting voltage potential at the output portal (AP) of the multiplexer (20) on the basis of criteria predefined by the sequence controller (12).

6. Analogue/digital converter arrangement according to Claim 5, wherein the logic circuit (10) evaluates the resulting voltage potential determined at the output portal (AP) of the multiplexer (20) on the basis of predefined criteria predefined by the sequence controller (12).

7. Analogue/digital converter arrangement according to Claim, wherein the logic circuit (10) compares the resulting voltage potential determined at the output portal (AP) of the multiplexer (20) with at least one predefined threshold value and stores the comparison result in at least one memory (50).

8. Analogue/digital converter arrangement according to Claim 7, wherein the logic circuit (10) outputs the comparison result stored in at least one memory (50) on request.

9. Analogue/digital converter arrangement according to one of Claims 1 to 8, wherein an interface unit (40) to a control device (80) is present and receives at least one command to carry out the test mode and/or to output the test result from the control device (80) and forwards it to the logic circuit (10).

10. Analogue/digital converter arrangement according to Claim 9, wherein the interface unit (40) receives the command to carry out the test mode each time the overall system is activated.

11. Method for checking a multiplexer for an analogue/digital converter, wherein the multiplexer (20) comprises an output portal (AP) and a plurality of channels (K1 to Kn) with at least one resistor (R1) and with at least one switch (S3, S4, S5), wherein the at least one switch (S3, S4, S5) connects an input portal (EP1 to EPn) of the channel (K1 to Kn) to the output portal (AP), and an analogue/digital converter (30), the analogue input (Sₐₙₐ) of which is connected to the output portal (AP), wherein at least one further switch (S1, S2, S6) for testing the multiplexer (20) is provided in at least one of the plurality of channels (K1 to Kn), which further switch connects the input portal (EP1 to EPn) of the at least one channel (K1 to Kn) and/or the output portal (AP) and/or the at least one channel (K1 to Kn) to a predefined voltage potential (Uᵢₙₜ, U_{P}, earth), wherein the multiplexer (20) has a first further switch (S1) which connects the channel (K1 to Kn) to an internal voltage potential (Uᵢₙₜ), a second further switch (S2) which directly connects the channel (K1 to Kn) to the earth potential (earth) and a third further switch (S6) which connects the input portal (EP1 to EPn) of the at least one channel (K1 to Kn) to a port supply voltage (U_{P}) via a diode (D1) and via a transistor (T1) which can be controlled by a control portal (SP1), wherein a logic circuit (10) is provided and switches the at least one switch (S3, S4, S5) and the at least one further switch (S1, S2, S6), wherein the corresponding switches (S1, S2, S3, S4, S5, S6) of the individual channels (K1 to Kn) are switched in a predefined order according to a sequence controller (12) implemented in the logic circuit (10) in order to check whether the respective channel (K1 to Kn) is coupled to another channel (K1 to Kn), wherein the logic circuit (10) is provided in the analogue/digital converter arrangement.

12. Method according to Claim 11, wherein the sequence controller (12) checks whether the respective channel (K1 to Kn) has an internal and/or external short circuit to another voltage potential.

13. Method according to Claim 12, wherein the at least one further switch (S1, S2, S6) is switched to a test mode and the sequence controller (12) is activated during the test mode.

14. Method according to one of Claims 11 to 13, wherein one of the channels (K1 to Kn) is operated as a stimuli channel and the remaining channels (K1 to Kn) are operated as measurement channels, wherein the individual channels (K1 to Kn) are operated as a stimuli channel in succession.

## Revendications

1. Ensemble convertisseur analogique-numérique doté d'un multiplexeur (20), qui comprend un portail de sortie (AP) et plusieurs canaux (K1 à Kn), avec au moins un commutateur (S3, S4, S5) et au moins une résistance (R1), dans lequel ledit au moins un commutateur (S3, S4, S5) relie un portail d'entrée (EP1 à EPn) du canal (K1 à Kn) au portail de sortie (AP), et à un convertisseur analogique-numérique (30) dont l'entrée analogique (Sₐₙₐ) est reliée au portail de sortie (AP), dans lequel il est prévu au moins un autre commutateur (S1, S2, S6) dans au moins l'un des multiples canaux (K1 à Kn) pour tester le multiplexeur (20), qui relie le portail d'entrée (EP1 à EPn) dudit au moins un canal (K1 à Kn) et/ou le portail de sortie (AP) et/ou ledit au moins un canal (K1 à Kn) à un potentiel de tension prédéterminé (Uᵢₙₜ, U_{P}, Masse), dans lequel il est prévu un circuit logique (10) qui commute ledit au moins un commutateur (S3, S4, S5) et ledit au moins un autre commutateur (S1, S2, S6), dans lequel un contrôleur de séquence (12) est mis en œuvre dans le circuit logique (10) de telle sorte que les commutateurs correspondants (S1, S2, S3, S4, S5, S6) des différents canaux (K1 à Kn) soient commandés dans un ordre prédéterminé afin de vérifier si le canal respectif (K1 à Kn) est couplé à un autre canal (K1 à Kn), dans lequel le circuit logique (10) est prévu dans l'ensemble convertisseur analogique-numérique,
**caractérisé en ce que**
le multiplexeur (20) comporte un premier autre commutateur (S1) qui relie le canal (K1 à Kn) à un potentiel de tension interne (Uᵢₙₜ), un deuxième autre commutateur (S2) qui relie directement le canal (K1 à Kn) au potentiel de masse (Masse) et un troisième commutateur (S6) qui relie le portail d'entrée (EP1 à EPn) dudit au moins un canal (K1 à Kn) à une tension d'alimentation de port (U_{P}) par l'intermédiaire d'une diode (D1) et d'un transistor (T1) pouvant être commandé par un portail de commande (SP1).

2. Ensemble convertisseur analogique-numérique selon la revendication 1, dans lequel le contrôleur de séquence (12) vérifie si le canal respectif (K1 à Kn) présente un court-circuit interne et/ou externe vers un autre potentiel de tension.

3. Ensemble convertisseur analogique-numérique selon la revendication 2, dans lequel ledit au moins un autre commutateur (S1, S2, S6) peut être commuté dans un mode de test et le contrôleur de séquence (12) est activé dans le circuit logique (10) pendant le mode de test.

4. Ensemble convertisseur analogique-numérique selon l'une des revendications 1 à 3, dans lequel il est prévu une alimentation en tension (70) et une unité de sélection (60) destinées à fournir au moins un potentiel de tension externe prédéterminé (U_{T}).

5. Ensemble convertisseur analogique-numérique selon l'une des revendications 1 à 4, dans lequel le circuit logique (10) utilise le convertisseur analogique-numérique (30) en tant qu'élément de mesure qui détermine le potentiel de tension résultant au niveau du portail de sortie (AP) du multiplexeur (20) sur la base de critères qui sont prédéterminés par le contrôleur de séquence (12).

6. Ensemble convertisseur analogique-numérique selon la revendication 5, dans lequel le circuit logique (10) évalue le potentiel de tension résultant déterminé au niveau du portail de sortie (AP) du multiplexeur (20) sur la base de critères prédéterminés qui sont prédéterminés par le contrôleur de séquence (12).

7. Ensemble convertisseur analogique-numérique selon la revendication, dans lequel le circuit logique (10) compare le potentiel de tension résultant déterminé au niveau du portail de sortie (AP) du multiplexeur (20) à au moins une valeur de seuil prédéterminée et stocke le résultat de la comparaison dans au moins une mémoire (50).

8. Ensemble convertisseur analogique-numérique selon la revendication 7, dans lequel le circuit logique (10) délivre sur demande le résultat de la comparaison stocké dans au moins une mémoire (50).

9. Ensemble convertisseur analogique-numérique selon l'une des revendications 1 à 8, dans lequel il est prévu une unité d'interface (40) avec un appareil de commande (80), qui reçoit au moins une instruction destinée au passage en mode de test et/ou à délivrer le résultat de test provenant de l'appareil de commande (80) et le transmet au circuit logique (10).

10. Ensemble convertisseur analogique-numérique selon la revendication 9, dans lequel l'unité d'interface (40) reçoit l'instruction de passer en mode de test lors de chaque mise en fonctionnement de l'ensemble du système.

11. Procédé de test d'un multiplexeur destiné à un convertisseur analogique-numérique, dans lequel le multiplexeur (20) comprend un portail de sortie (AP) et plusieurs canaux (K1 à Kn), avec au moins une résistance (R1) et avec au moins un commutateur (S3, S4, S5), dans lequel ledit au moins un commutateur (S3, S4, S5) relie un portail d'entrée (EP1 à EPn) du canal (K1 à Kn) au portail de sortie (AP), et à un convertisseur analogique-numérique (30) dont l'entrée analogique (Sₐₙₐ) est reliée au portail de sortie (AP), dans lequel il est prévu au moins un autre commutateur (S1, S2, S6) dans au moins l'un des multiples canaux (K1 à Kn) pour tester le multiplexeur (20), qui relie le portail d'entrée (EP1 à EPn) dudit au moins un canal (K1 à Kn) et/ou le portail de sortie (AP) et/ou ledit au moins un canal (K1 à Kn) à un potentiel de tension prédéterminé (Uᵢₙₜ, U_{P}, Masse), dans lequel le multiplexeur (20) comporte un premier autre commutateur (S1) qui relie le canal (K1 à Kn) à un potentiel de tension interne (Uᵢₙₜ), un deuxième autre commutateur (S2) qui relie directement le canal (K1 à Kn) au potentiel de masse (Masse) et un troisième autre commutateur (S6) qui relie le portail d'entrée (EP1 à EPn) dudit au moins un canal (K1 à Kn) à une tension d'alimentation de port (U_{P}) par l'intermédiaire d'une diode (D1) et d'un transistor (T1) pouvant être commandé par un portail de commande (SP1), dans lequel il est prévu un circuit logique (10) qui commute ledit au moins un commutateur (S3, S4, S5) et ledit au moins un autre commutateur (S1, S2, S6), dans lequel, après une commande de séquence (12) mise en œuvre dans le circuit logique (10), les commutateurs correspondants (S1, S2, S3, S4, S5, S6) des différents canaux (K1 à Kn) sont commutés dans un ordre prédéterminé pour vérifier si le canal respectif (K1 à Kn) est couplé à un autre canal (K1 à Kn), dans lequel le circuit logique (10) est prévu dans le dispositif de conversion analogique-numérique.

12. Procédé selon la revendication 11, dans lequel le contrôleur de séquence (12) vérifie si le canal respectif (K1 à Kn) présente un court-circuit interne et/ou externe vers un autre potentiel de tension.

13. Procédé selon la revendication 12, dans lequel ledit au moins un autre commutateur (S1, S2, S6) est commuté dans un mode de test, et le contrôleur de séquence (12) est activé pendant le mode de test.

14. Procédé selon l'une des revendications 11 à 13, dans lequel l'un des canaux (K1 à Kn) est utilisé en tant que canal de stimulation et les autres canaux (K1 à Kn) sont utilisés en tant que canaux de mesure, dans lequel les différents canaux (K1 à Kn) sont successivement utilisés en tant que canal de stimulation.
